# EUROPEAN PATENT APPLICATION

(11) **EP 0 671 656 A2**
(43) Date of publication of application: **13.09.1995**
(21) Application number: 95301482.6
(22) Date of filing: 07.03.1995
(51) Int. Cl.: G03C 7/30, G03F 3/10

(54) **Silver halide light-sensitive color photographic material and method of preparing color proof**

(30) Priority: 11.03.1994 JP 41299/94
(71) Applicant: KONICA CORPORATION, Tokyo 163 (JP)
(72) Inventor: Masumi, Satoshi, Odawara-shi, Kanagawa-ken (JP); Ohkawachi, Susumu, Odawara-shi, Kanagawa-ken (JP)
(74) Representative: Simpson, Alison Elizabeth Fraser

(57) **Abstract**

A silver halide color photographic light-sensitive material is disclosed, comprising a support having thereon light-sensitive component layers including a blue light-sensitive, yellow image forming layer; a green light-sensitive, magenta image forming layer; and a red light-sensitive, cyan image forming layer, wherein at least one of the light-sensitive component layers contains silver halide grains having a chloride content of 80 mol% or more; when the photographic material is exposed to green light, ratios of blue light density (DB) to green light density (DG), DB/DG at a low density (DG=0.5) and at a high density (DG=1.5) are each within a range of 0.3 to 0.6. A color proof is prepared by subjecting the color photographic material to light-exposure based on color-separated halftone dot image information.

## Description

### Field of the Invention

The present invention relates to a silver halide light-sensitive color photographic material and a method of producing a color image by the use thereof. More specifically, the present invention relates to a silver halide light-sensitive color photographic material suitable for producing a color proof from a transparent-type black-and-white dot image original made from color-separated color original.

### Background of the Invention

Heretofore, in the process of plate-making and printing of a color image, as a method of improving drawbacks accompanied with Overlay process or Surprint process, which has been used for producing a color image for proof, or color proof, from a plurality of black-and-white dot images obtained by color separating a color original and converting them into dot images. The method of using a silver halide light-sensitive color photographic material is disclosed in, for example, Japanese Patent O.P.I. Publications No. 62-280849(1987), No. 62-280747(1987 through No. 62-280750(1987), etc. However, the silver halide emulsion used for this purpose is a chlorobromide emulsion with a high silver bromide content, and there is no description sufficient to the practical use of a high silver chloride content emulsion, which has enhanced adaptability to rapid development and environmental compatibiltiy, putting into practice.

Moreover, no printing for inspection only for the confirmation of the positions of characters and the images, recently. The color proof comes to be used as printing for the confirmation of color tone confirmed to the image tone and a market demand for the qualities in this respect is rising. Since the spectral absorption is different between the dye used in the light-sensitive color photographic material and the printing ink, a variety of attempts for the dyes used in the photographic material to approximate to the color of the printing ink by the use of various techniques in the photographic light-sensitive material for color proof have been made. Especially, in the magenta dye, the method of mixing the magenta dye-forming coupler and the yellow-dye-forming coupler is disclosed in the Japanese Patent O.P.I. publication 2-139542(1990).

When high silver chloride content emulsion is used, however, even if a magenta dye-forming coupler and a yellow dye-forming coupler are mixed, as in the case of a chlorobromide emulsion, slippage of the image tone of the high density portion and the low density portion is large. When density and dot gain are adjusted, the hue shifts largely. It is needed to raise the density extremely to match the hue. This was a problem on practical use.

Accordingly, one which does not cause a failure to the hue of the magenta dye even in the case where a high silver chloride content emulsion was used, has been a demand.

### Summary of the Invention

Against the problem of the above-mentioned, the object of present invention is to provide a silver halide light-sensitive color photographic material and a method of forming a dye image by the use thereof.

The above-mentioned problems of the present invention can be accomplished by the following constitution.
(1) A silver halide color photographic light-sensitive material comprising a support having thereon plural light-sensitive component layers including a blue light-sensitive layer containing a blue light-sensitive silver halide emulsion and a yellow coupler, a green light-sensitive layer containing a green light-sensitive silver halide emulsion and magenta coupler and a red light-sensitive layer containing a red light-sensitive silver halide emulsion and cyan coupler, wherein at least one of the light-sensitive component layers contains a silver halide emulsion containing silver halide grains having an chloride content of 80 mol% or more; density ratios of (DB₁/DG₁) and (DB₂/DG₂) are each within a range of 0.3 to 0.6, in which DG₁ is a green light density of 0.5, DB₁ is a blue light density when said photographic material is exposed to green light in an amount that gives said photographic material a green light density of 0.5, DG₂ is green light density of 1.5 and DB₂ is a blue light density when said photographic material is exposed to green light in an amount that gives said photographic material a green light density of 1.5.
(2) A method of preparing a color proof by subjecting a silver halide color photographic light-sensitive material comprising a support having thereon plural light-sensitive component layers including a blue light-sensitive layer containing a blue light-sensitive silver halide emulsion and yellow coupler, a green light-sensitive layer containing a green light-sensitive silver halide emulsion and magenta coupler and a red light-sensitive layer containing a red light-sensitive silver halide emulsion and cyan coupler to exposure based on halftone dot image information comprised of color-separated yellow, magenta and cyan image information, and black image information, wherein said silver halide color photographic light sensitive material is the color photographic material as above-described.

### Detailed Description of the Invention

In the present invention, ratios of blue light density (DB) to green light density (DG) at a low density portion (DG = 0.5) and a high density portion (DG = 1.5) are respectively within a range of 0.3 to 0.6, preferably 0.35 to 0.55 when the photographic material is exposed to green light in amounts that give the photographic material a green densitied of 0.5 and 1.5, respectively. The photographic material is exposed to light through Wratten filter No. 61 (Product of Eastman Kodak). In the invention, the words "a blue light density" or " a green light density" means a density obtained from blue light or green light absorbance, which correspond respectively to a yellow density or magenta density.

In a preferred embodiment of the invention, the green light-sensitive layer further contains a yellow coupler. The yellow coupler is contained preferably in a ratio thereof to the magenta coupler within a range of 0.02 to 0.5. The pKa value of the yellow coupler to be mixed (pKaY) is preferably smaller than that of the magenta coupler (pKaM) by 0.1 to 2.5, more preferably 0.2 to 2.0. The pKa value can be determined from spectral absorption spectrum of a couple dissolved in a water/ethanol solution (80/20).

In another preferred embodiment of the invention, a green light-sensitive silver halide emulsion is further contained in the a yellow dye image forming blue light-sensitive layer in a ratio of 0.02 to 0.5. The green-sensitive emulsion to be contained have a sensitivity equivalent to or at least 50% of that of the green light-sensitive layer containing the magenta coupler.

In another preferred embodiment of the photographic material of the invention, is further provided a green light-sensitive layer containing a yellow coupler, which has a sensitivity equivalent to or slightly lower than that of the green light-sensitive layer containing the magenta coupler. This yellow dye image forming, green-sensitive layer may be provided at the position adjacent to the maenta dye image forming layer. An interlayer may be provided between them.

As dye-forming coupler used in the silver halide light-sensitive material of the present invention, any compound which is, upon reaction with an oxidation product of a developing agent, capable of producing a coupling product having a spectral absorption maximum in the wave length longer than 340nm can be used. As especially, typical products, a yellow dye-forming coupler which has a spectral absorption peak in the wave length region between 350 and 500 nm., a magenta dye-forming coupler which has a spectral absorption peak wave length in the wave length region between 500 and 600 nm, a cyan dye-forming coupler which has spectral absorption peak wave length in the wave length region between 600 and 750nm. These are well known in the art as typical dye-forming couplers are cited.

As cyan dye forming dye-forming coupler which can be used preferably in the silver halide light-sensitive photographic material of the present invention, the dye-forming coupler represented in the under left column on page 5 of Japanese Patent O.P.I. Publication No. 4-114154(1992) as formulas (C-I) and (C-II) can be mentioned. As more specific compounds, those which are described in the lower right column on page 5 through in the upper left colunm on page 6 of the same as CC-1-CC-9 can be mentioned.

As the magenta dye-forming coupler which can be used preferably in the silver halide light-sensitive photographic material of the present invention, dye-forming couplers disclosed in the upper right column on page 4 of in Japanese Patent O.P.I. Publication No. 4-114154 (1992) by formula (M-I) can be mentioned. As more specific compounds, those described in the upper right column on page 5 of the same as MC-1 through MC-7 can be mentioned.

As yellow dye-forming coupler which can preferably be used in the blue light-sensitive layer of the silver halide light-sensitive photographic material of the present invention, the dye-forming coupler represented in the upper right column on page 3 of Japanese Patent O.P.I. Publication No. 4-114154(1992) formula (Y-I) can be mentioned. More specifically, those described in the lower left column on page 3 of Japanese Patent O.P.I. Publication 4-114154 issues (1992)-4 as YC-1-YC-9 can be mentioned. Among these, exemplified compounds YC-8 and YC-9 described in the upper left column on the page 4 of the same are more preferable in the light of tone reproduction of yellow image.

As yellow dye-forming coupler to be added to the magenta image-forming green light-sensitive layer or another layer, other than the above-mentioned yellow dye-forming couplers, those described in the upper left column on pagel3 through the lower left column on page 16 of Japanese Patent O.P.I. Publication No. 2-139542(1990) as Y-1 through Y-58 can be mentioned.

Hereinbelow, specific examples of the yellow dye-forming coupler which is added to the magenta image-forming green light-sensitive layer of the photographic material of the present invention are given.

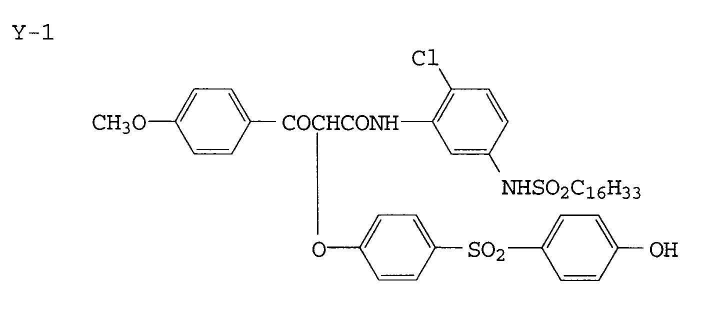

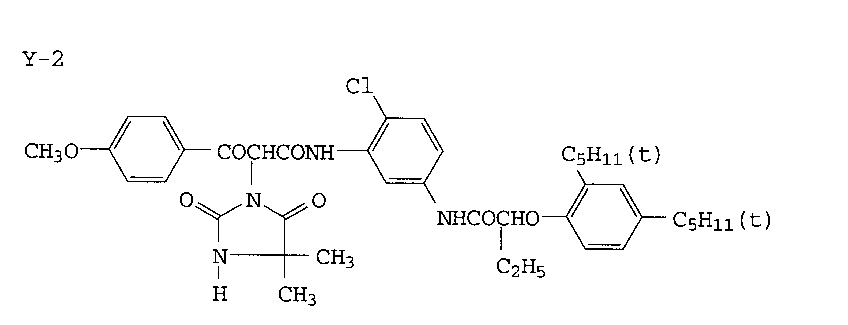

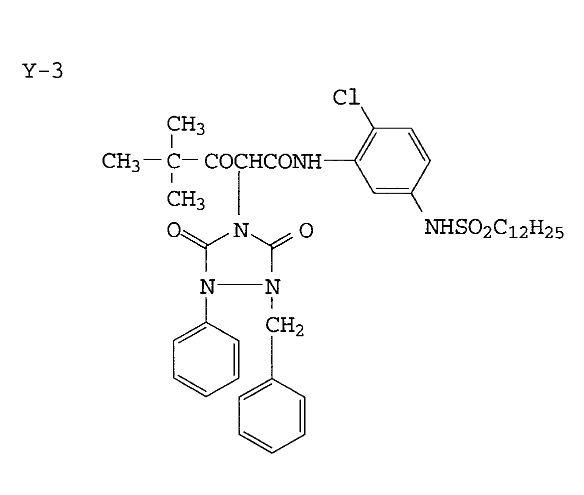

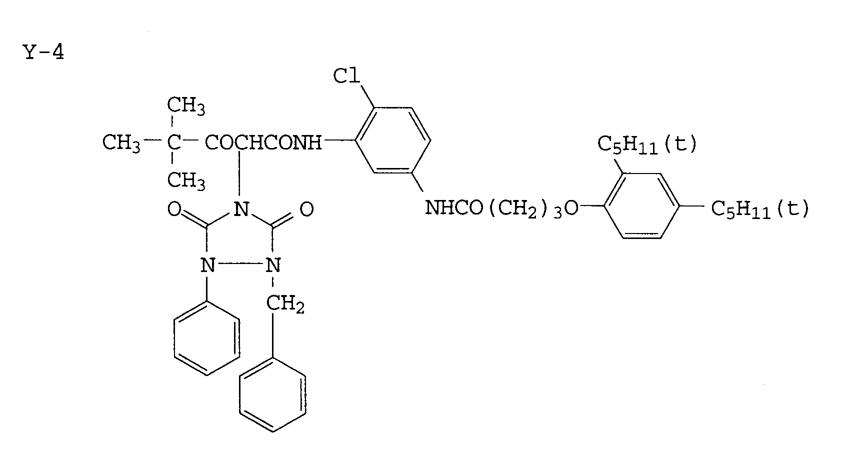

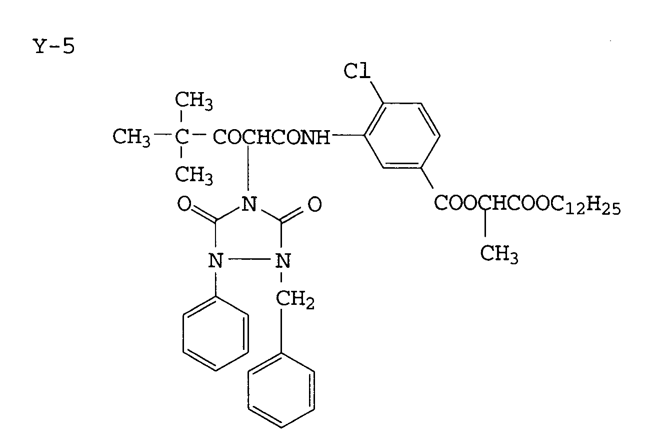

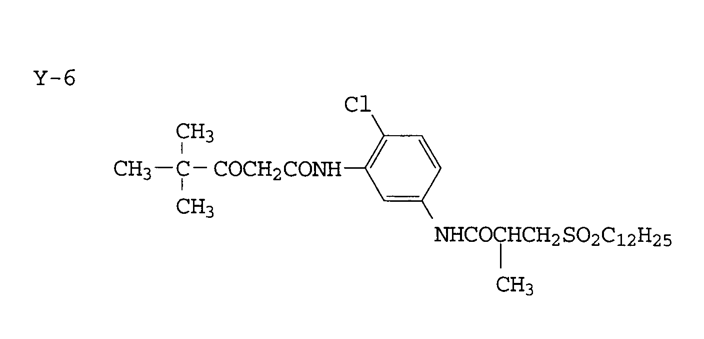

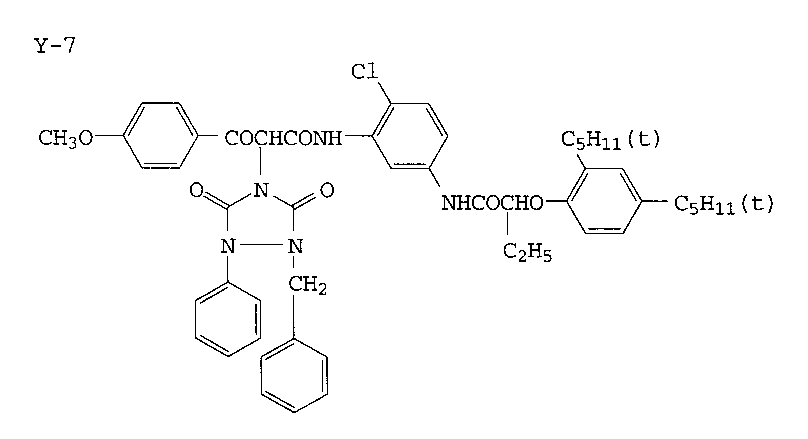

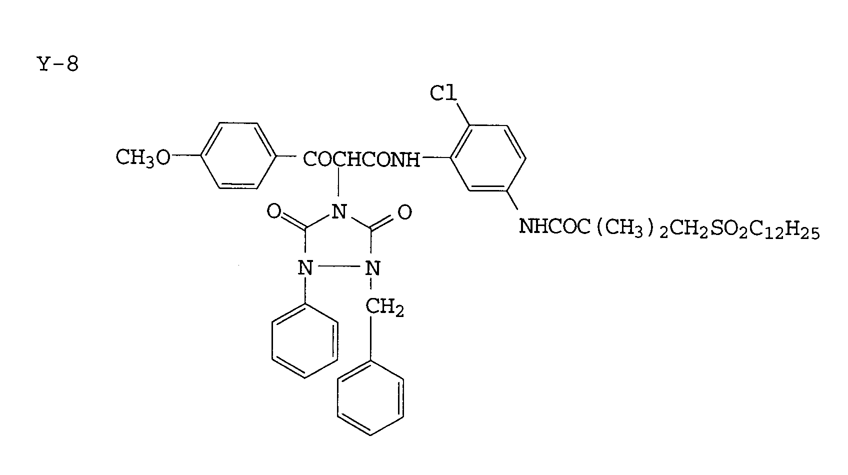

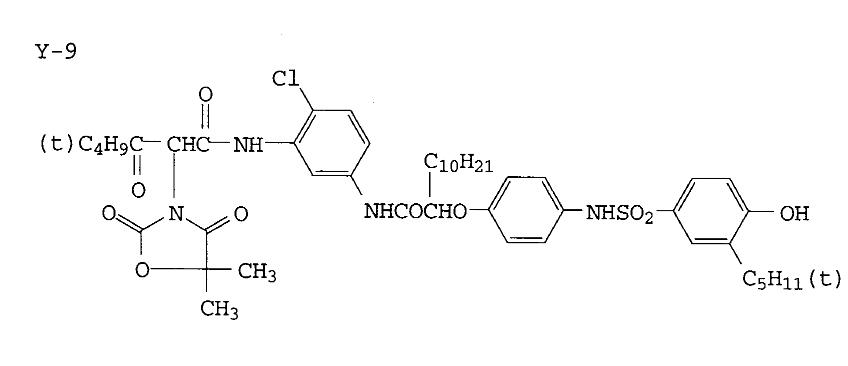

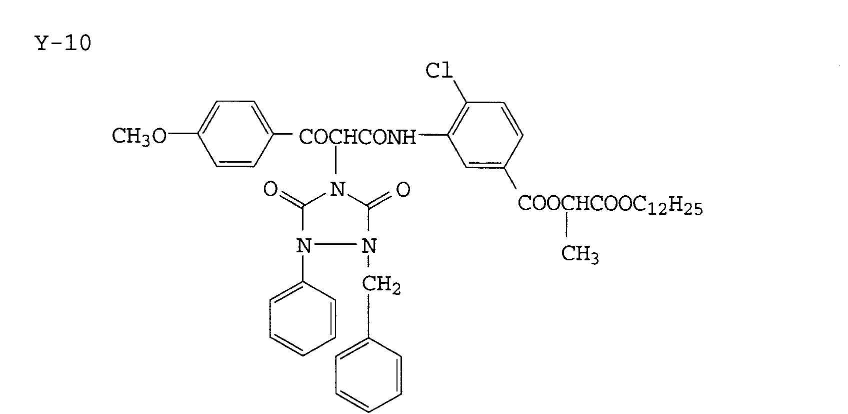

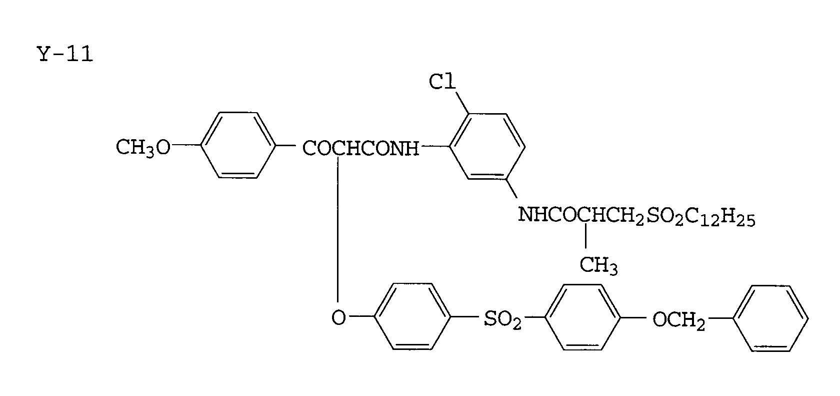

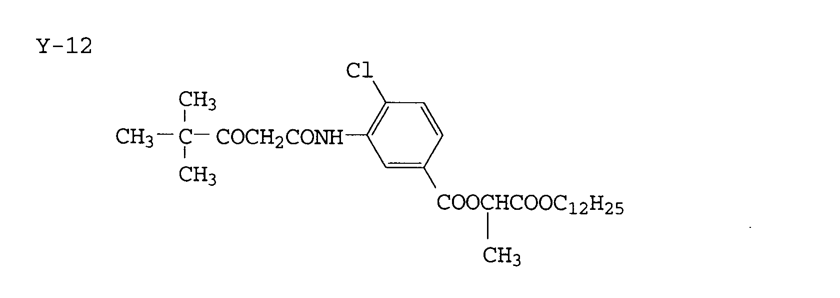

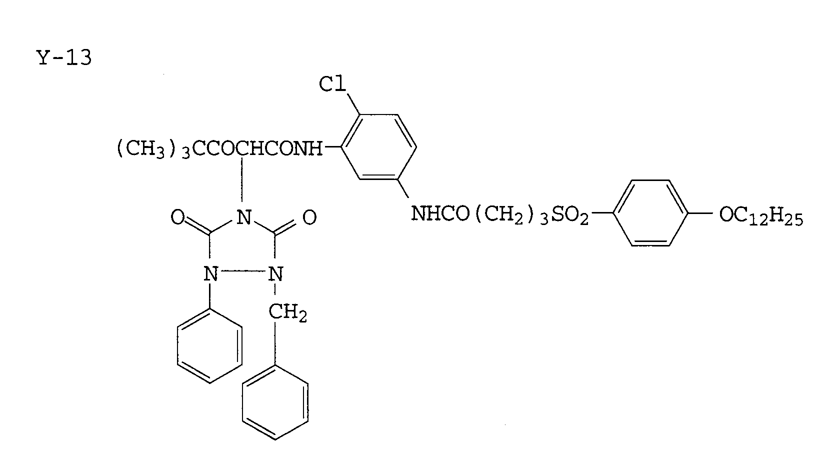

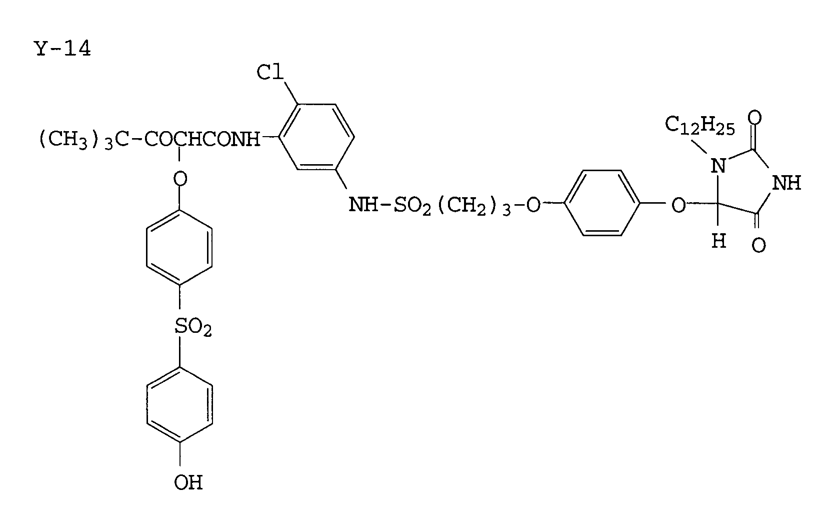

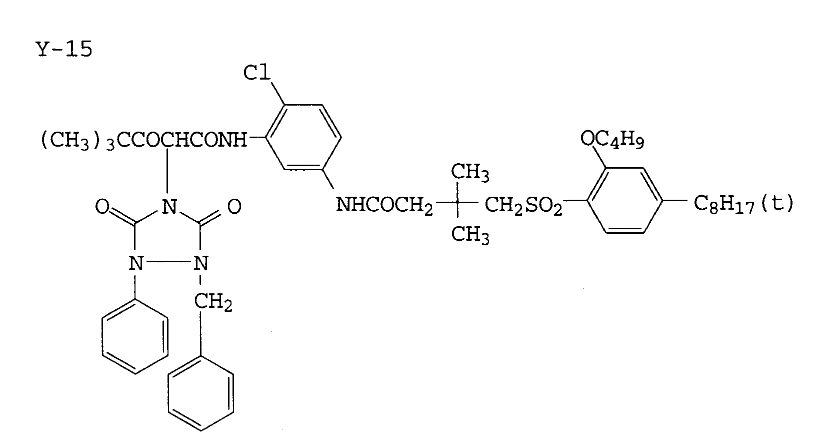

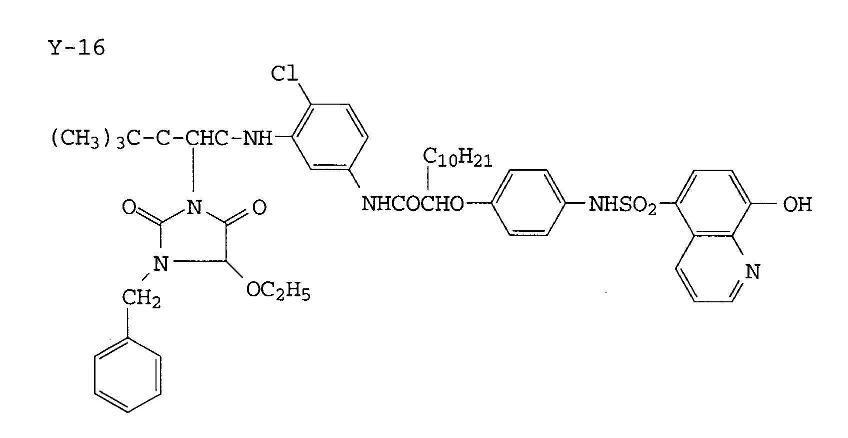

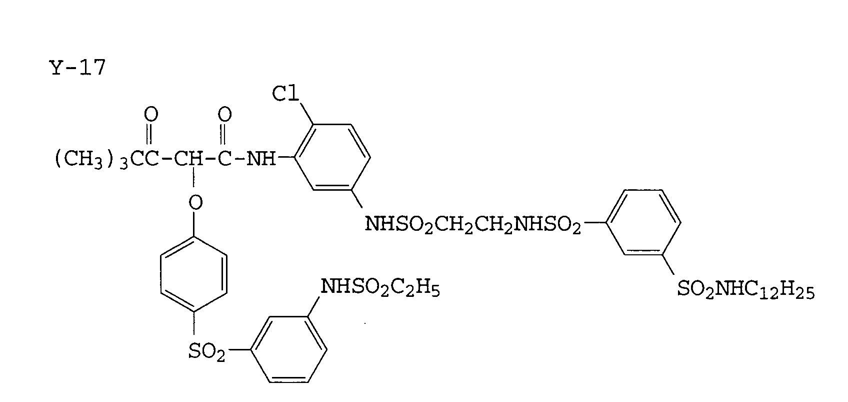

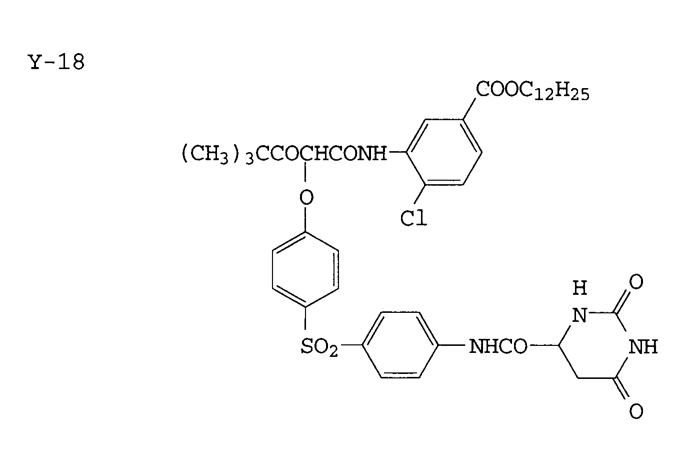

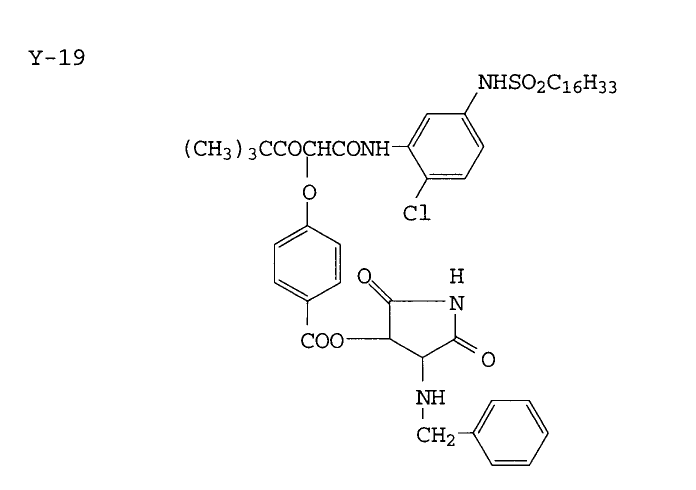

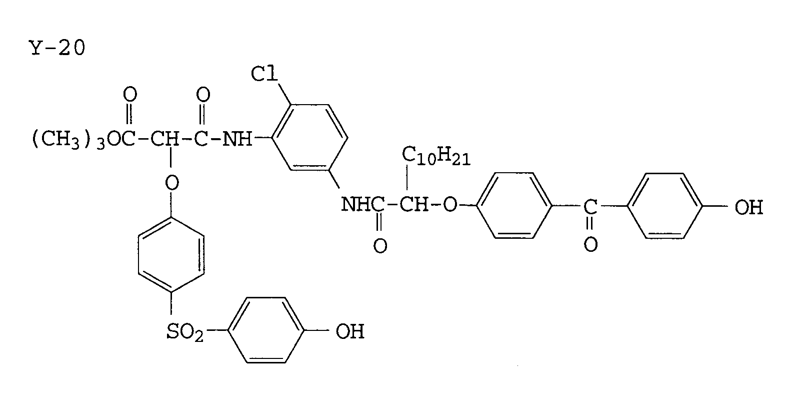

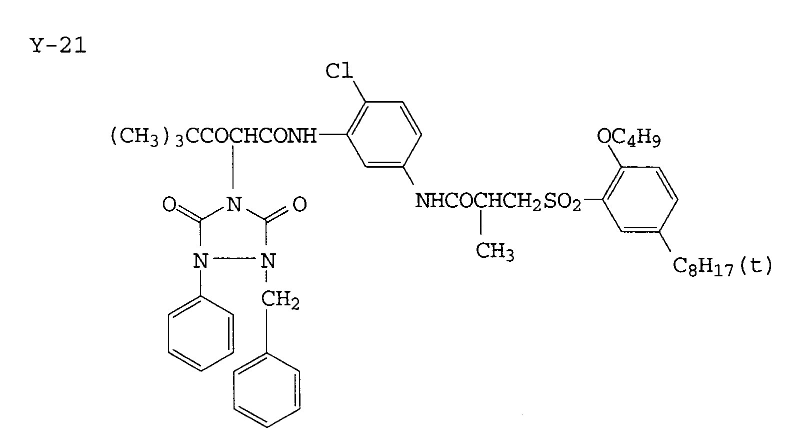

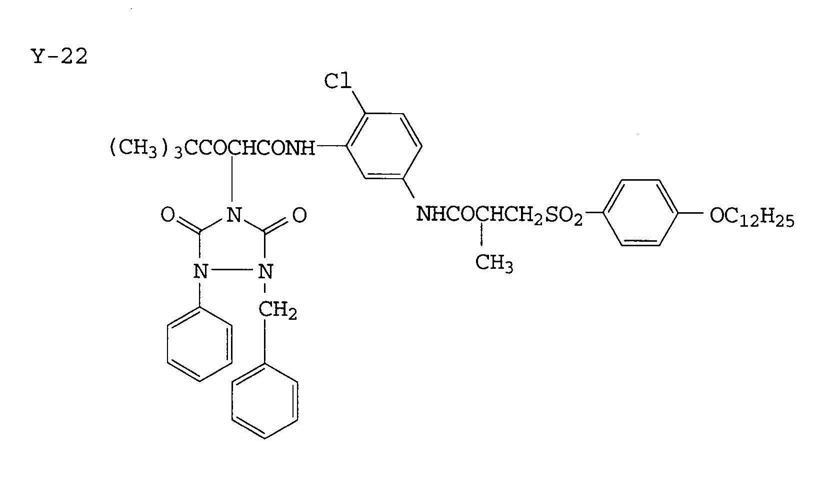

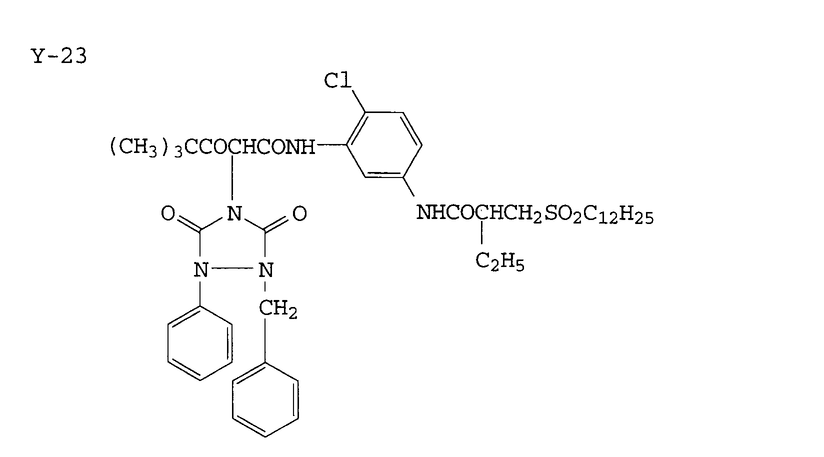

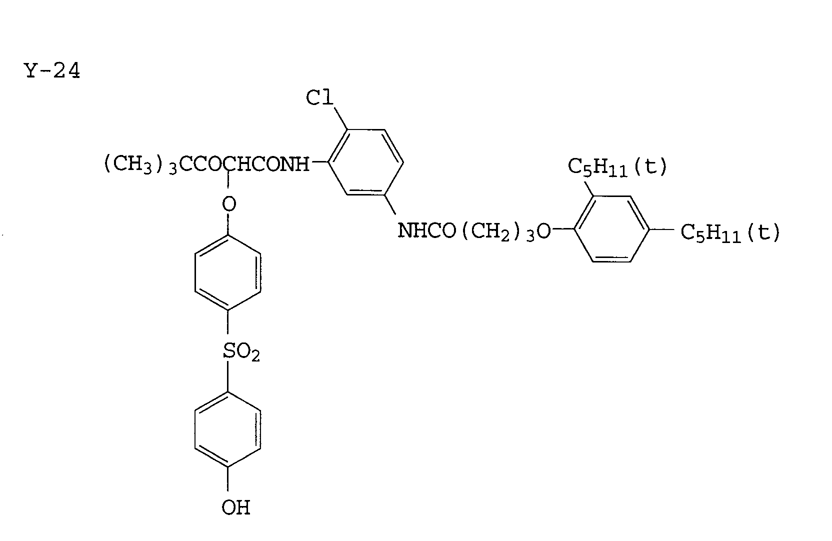

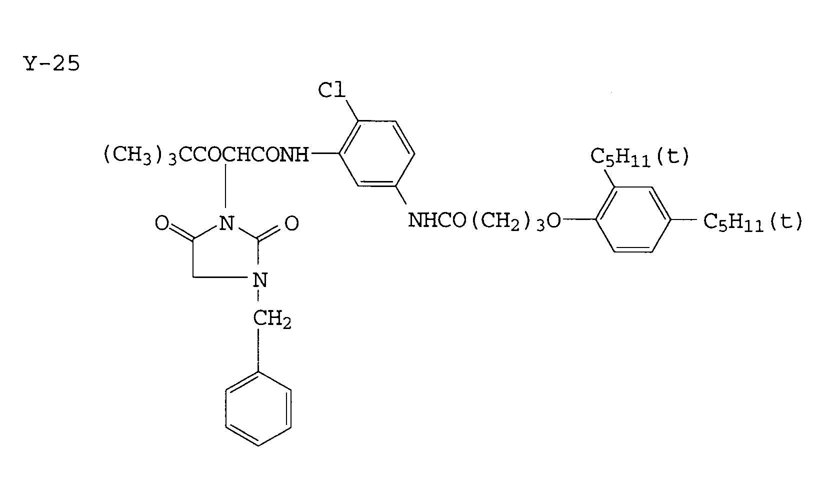

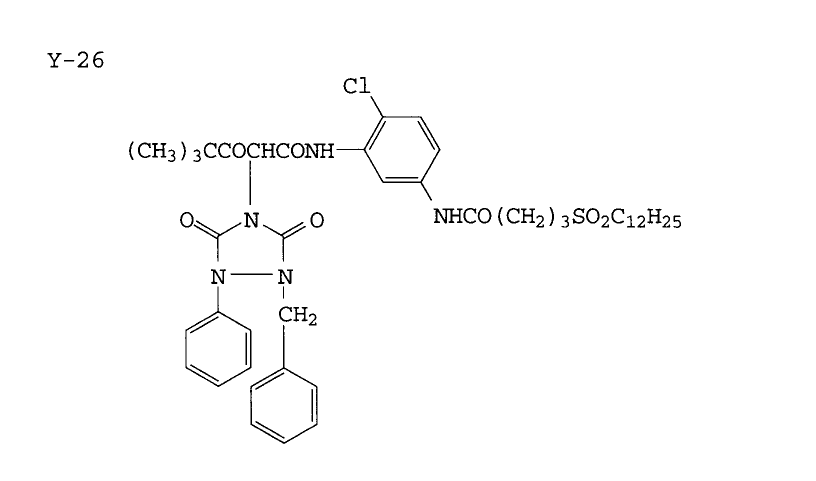

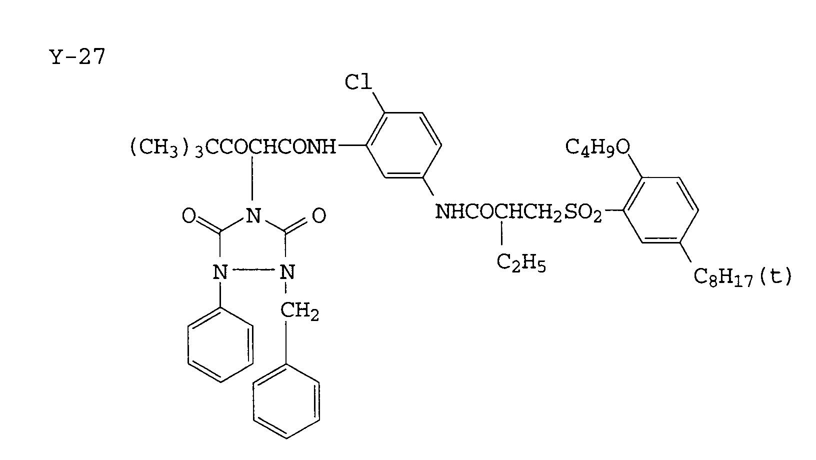

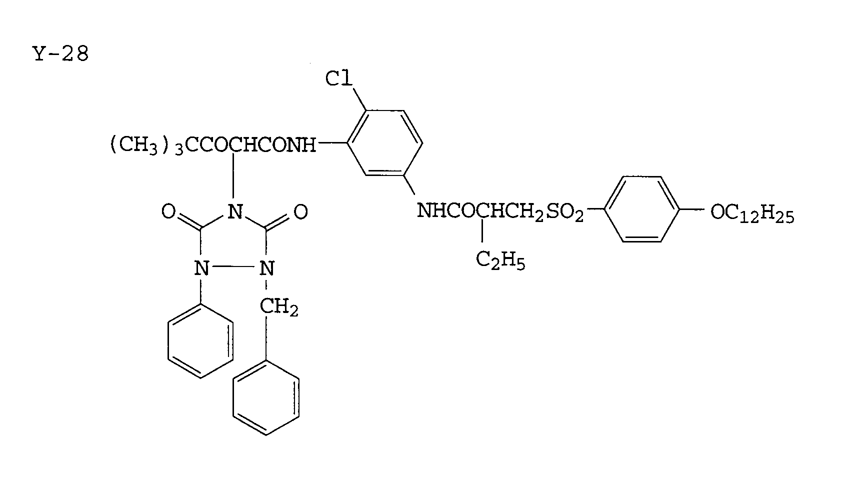

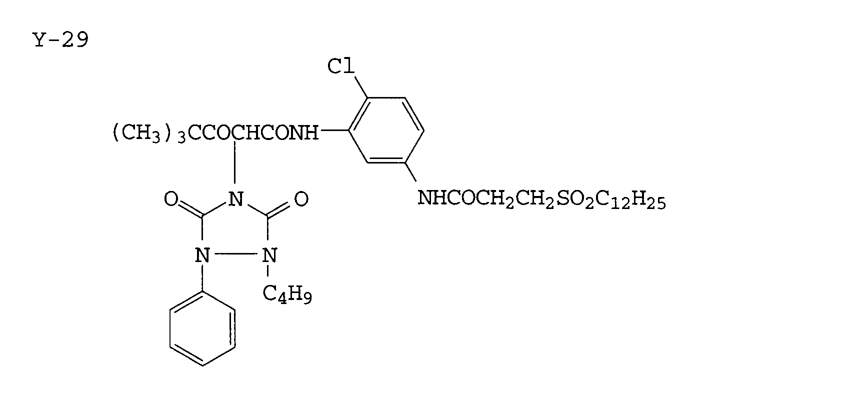

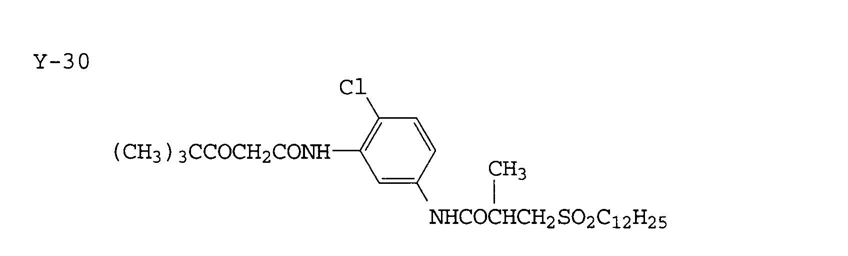

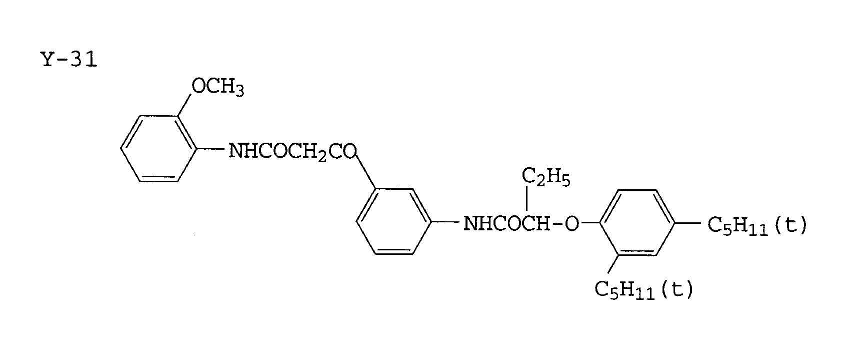

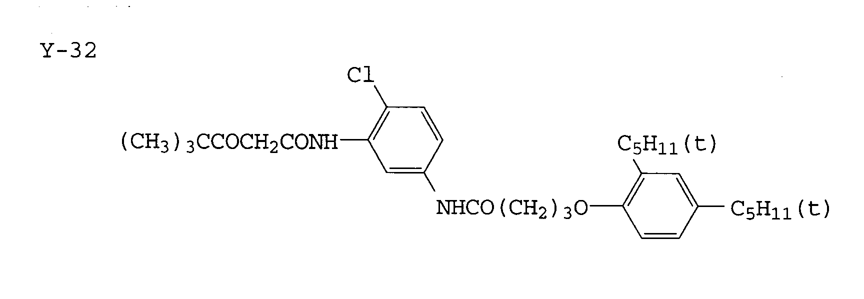

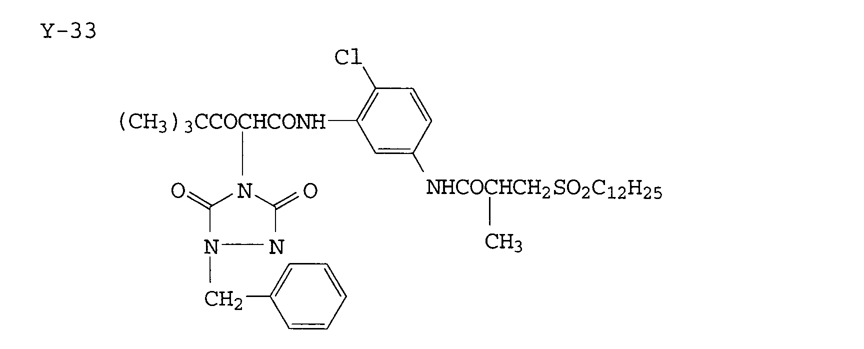

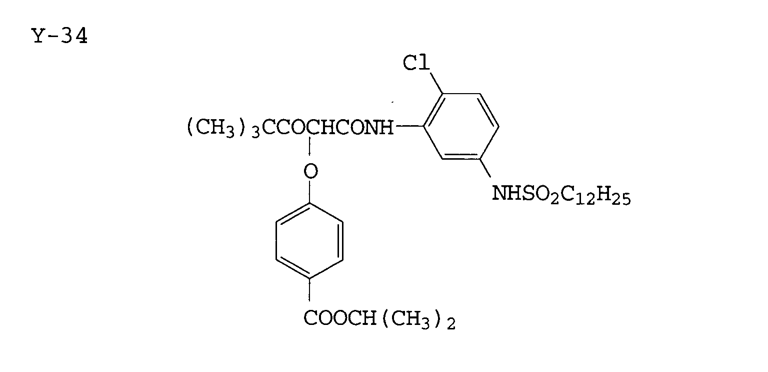

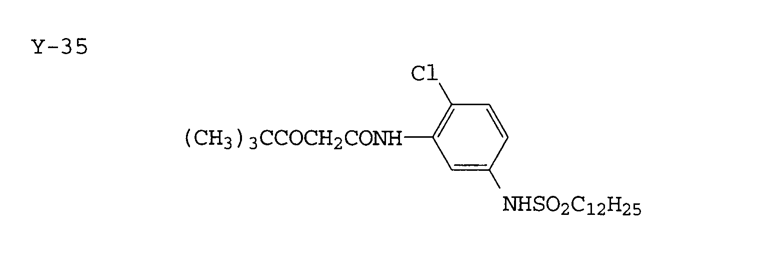

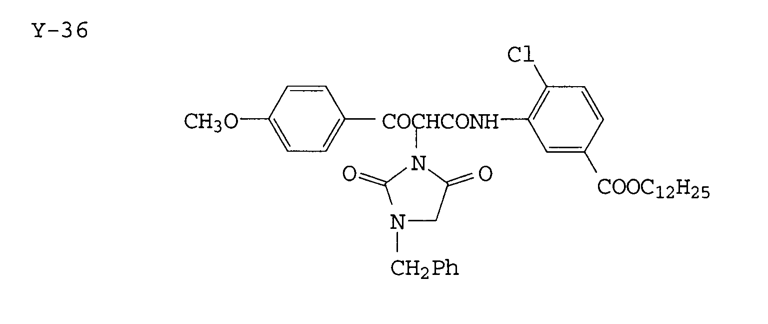

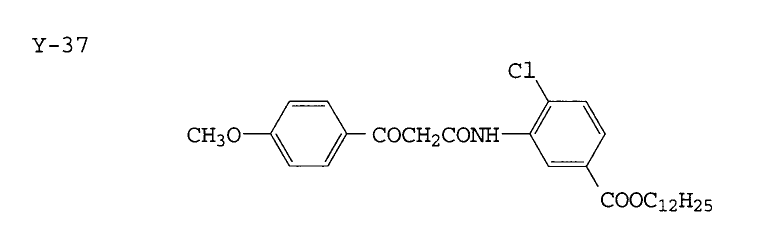

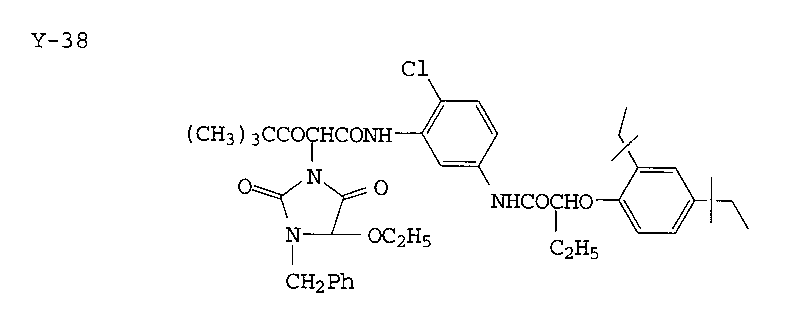

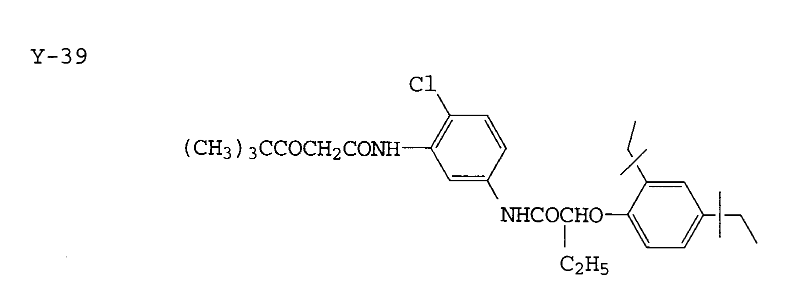

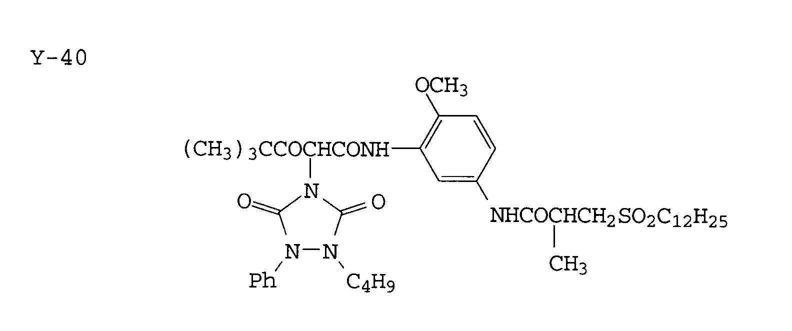

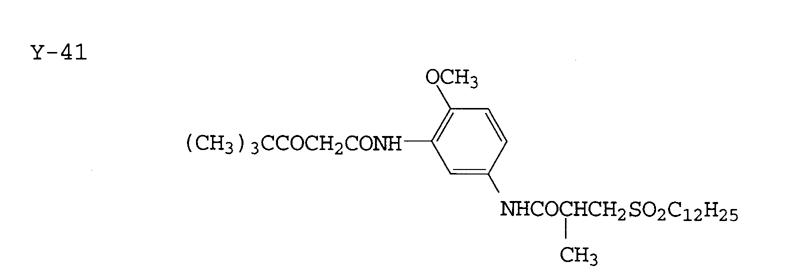

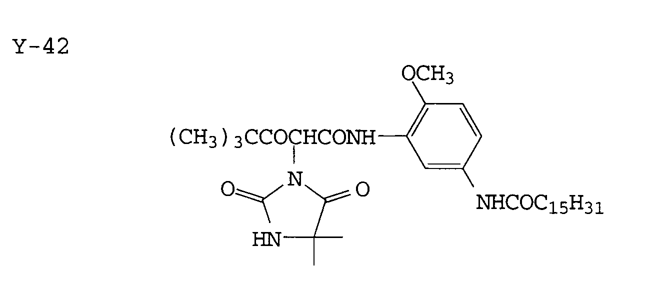

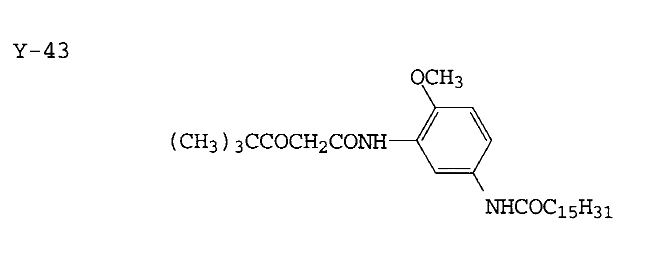

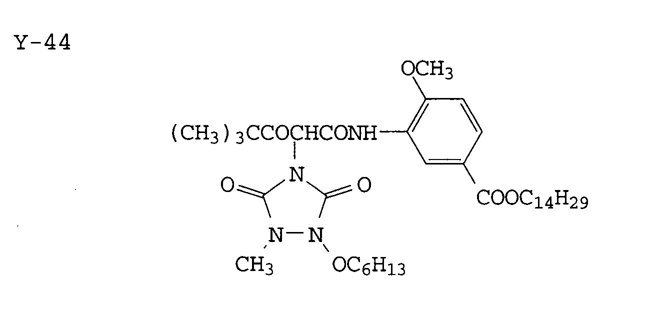

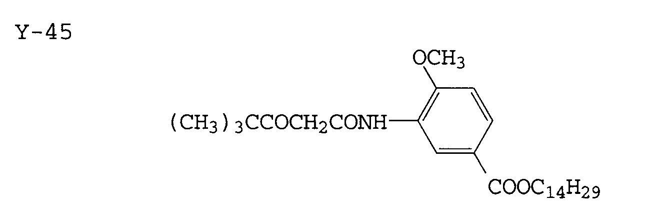

When the dye-forming coupler used in the silver halide light-sensitive photographic material of the present invention is added, oil-in-water type emulsification method is employed, in which the coupler is usually dissolved in a water-immiscible high boiling point organic solvent having boiling point of more than 150°C, together with, if necessary, a low boiling point organic solvent and/or a solvent which is miscible with water and, then emulsified in by using the surfactant in an aqueous solution containing a hydrophilic binder such as an aqueous gelatin solutions. As dispersion means, a mixing machine, a homogenizer, a colloid mill, a flow-jet mixer, an ultrasonic homogenizer etc. can be used. After completion of or during the emulsification process, a step of removing the low boiling point organic solvent process can be employed.

As high boiling point organic solvent which can be used to dissolve and disperse the dye-forming coupler and other photographically, useful organic compounds such as ultraviolet ray absorbent or anti-color-staining agent, etc., which are explained hereinbelow, a high boiling point organic solvent of which vapor pressure at 100°C is lower than 0.5 mmHg is preferable. As specific examples, exemplified Compounds II-1 through II-9, III-1 through III-6,II-1 through II-38 disclosed in Japanese Patent O.P.I. Publication No. 63-103245(1988), exemplified Compounds H-1 through H-22 disclosed in Japanese Patent O.P.I. Publication No. and J No. 1-196048 (1989), exemplified Compounds II-1 through II-38 disclosed in Japanese Patent O.P.I. Publication No. 64-66646(1989) and other compounds such as phosphine oxide compounds can be mentioned: Also phosphate such as tricresylphosphates, phosphine oxides are preferably used.

As the specific examples of the phosphinoxide compounds, for example those having following structures can be mentioned.
1.

   O=P-(C₈H₁₇(i))₃
2. 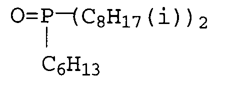
3. 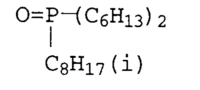
4. 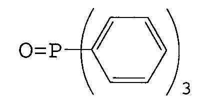
5. 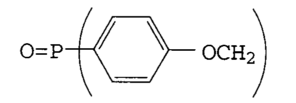
6. 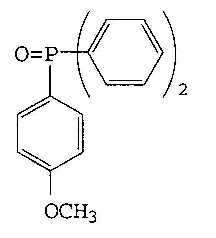
7.

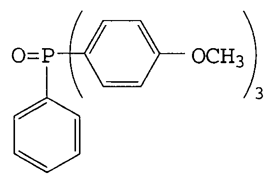

As low boiling point organic solvent, ethyl acetate is preferably used. Moreover, as preferable surfactant used for dispersion, a compound having therein a hydrophobic group containing 8-30 carbon atoms in one molecule, and a - SO₃M group or a - OSO₃M group, in which M represents a hydrogen atom or a cation, can be mentioned. As specific examples of such preferable surfactants, exemplified anionic surfactants A-1 through A-11 disclosed in the upper left column to the upper right column on page 15 of Japanese Patent O.P.I. Publication No. 64-26854(1989) and, more preferably, A-11 and A-8 can be mentioned.

It is also preferable that these dispersions are added to a coating solution comprising a silver halide emulsion, and are subsequently subject to coating. It is preferable that these dispersions are added to the coating solution within 10 hours after dispersion, preferably whithin three hours, and more preferably, within 20 minutes after dispersion.

For the purpose of shifting absorption wave length of a dye-forming dye, Compound(d-ll) disclosed in the upper left column on page 10 of Japanese Patent O.P.I. Publication No. 4-114154(1992) or Compound(A'-1), disclosed on page 35 of the same, may also be used. Besides these, fluorescent dye-releasing compounds disclosed in U.S. Patent No. 4,774,187 can also be used.

There is no specific limitation as to coating amount of the dye-forming coupler, if it can give satisfactorily high density, can be obtained, however, preferably, 1x10⁻³ to 5 mols per mol of silver halide, and, more preferably, 1x10⁻² to 1 mol per mol of silver halide can be used.

The anti-fading agent can be used together with the magenta dye-forming coupler used in the present invention.

As first type of this compound, phenyl ether-type compounds represented by formulas I and II in the upper left column through upper right column on page 3 of Japanese Patent O.P.I. Publication No. 2-66541 (1990) can be mentioned. More specifically, exemplified Compounds I-1 through I-32 and Compounds II-1 through II-18 disclosed in the lower right column on page 3 through upper right column on page 5 of the same reference can be mentioned. More specifically, Compounds I-10 and I-13 are preferable.

As the second type anti-fading agent preferably used together, phenol type compounds represented by formula IIIB of the Japanese Patent O.P.I. Publication No. 3-174150(1991) can be mentioned. Among these, Compounds III-1, III-12, III-13 and III-14 are more preferable and, especially preferable compound is the compound represented by III-14.

As the third anti-fading agent preferably used in the present invention, amine type compounds represented by formula A disclosed in Japanese Patent O.P.I. Publication No. 64-90445(1989) can be mentioned. As specific examples, exemplified Compounds A-1 through A-15 disclosed in the upper right column of the same reference can be mentioned, and, among these, A-3 is particularly advantageous.

It is preferable to use an anti-fading agent together with a yellow-dye-forming coupler and a cyan dye-forming coupler of the present invention. As preferable anti-fading agent, a compound represented by the general formula I' in the upper left column on page 8 of Japanese Patent O.P.I. Publication No. 1-196049(1989) and Japanese Patent Application No. 3-185113(1991) can be mentioned. As more preferable compounds, Compounds I-10 and I-13 disclosed in the upper left column on pages 8 of Japanese Patent O.P.I. Publication No. 1-196049 issue (1989) can be mentioned. Furthermore, as more preferable compound, Compounds I-10 and I-13 disclosed in the upper left column and in the upper right column on page 9 of the same can be mentioned.

These anti-fading agents used together with the magenta, yellow and the cyan dye forming d couplers are preferably added to the same oil particles in which dye-forming coupler is incorporated, at a proportion of 0.1 through 3 mols per mol of dye-forming coupler and, more preferably, in a range of 0.5 to 1.5 mols. In this case, it is preferable that two or more different kinds of anti-fading agents are used in combination.

The anti-discoloring agent is preferably used together with different kinds of compounds. The phenol type compound shown by formula IIIB described in Japanese Patent O.P.I. Publication No. 3-17450 (1991) and the phenyl ether type compound shown by formula I and II described in the upper right column on page 3 of Japanese Patent O.P.I. Publication 2-66541(1990) are given as preferable examples. Further, the combination of the phenol-type compounds represented by formula IIIB disclosed in Japanese Patent O.P.I. Publication No. 3-17450(1991) and the amine-type compounds disclosed in Japanese Patent O.P.I. Publication No. 64-90445(1989) can be mentioned as a preferable example of such combination.

As ultraviolet-ray absorbent used in the present invention, those having a spectral absorption peak at wave length outside of purple, or not greater than 400 nm and the compound whose molar absorption coefficient is 5000 or less can be mentioned. As specific preferable compound, compounds represented by general formula III-3 disclosed in Japanese Patent O.P.I. Publication No. 1-250944 (1989), and compounds represented by formula I disclosed in Japanese Patent O.P.I. Publication 4-1633 issues (1992) can be mentioned. As examples of specific compounds, exemplified Compounds IIIc-1 through IIIc-17 disclosed in Japanese Patent O.P.I. Publication 1-250944 (1989),exemplified Compounds III-1 through III-24 disclosed in Japanese Patent O.P.I. Publication No. 64-66646(1989), exemplified Compounds UV-1L through UV-22L disclosed in Japanese Patent O.P.I. Publication No. 63-187240(1988) and UV-1S-UV through 19S disclosed in the same reference and exemplified Compounds I-1 through I-23 disclosed in Japanese Patent O.P.I. Publication No. 4-1633(1992),etc. can be mentioned.

As especially preferable compounds among these, IIIc-7 and IIIc-12 disclosed in the upper left column on page 15 of Japanese Patent O.P.I. Publication No, 1-250944(1989) and liquid-type ultraviolet ray absorbent UV-23L disclosed in Japanese Patent O.P.I. Publication No. 63-187240(1988) can be mentioned.

It is preferable that these ultraviolet ray absorbents are added according to the method of dispersion mentioned above.

In the present invention, the high boiling point organic solvent used in the ultraviolet ray absorbent is added to the ultraviolet ray absorbent at a weight ratio of 0.3 - 0. Preferably, it is 0.1 - 0 and more preferably, 0.

As high boiling point organic solvent, the compound used for the dispersion of the above-mentioned dye-forming coupler is preferably used.

It is preferable that the in the present invention, the ultraviolet ray absorbent is added to non-light-sensitive layer. Furthermore.

In the present invention, it is preferable to add a fine grain powder (so-called matting agent) to the farthest layer from the support or the surface layer. As matting agent, those which are disclosed at lines 9 - 20 in the upper right column on page 2 of Japanese Patent O.P.I. Publication No. 2-73250(1990) are preferable. The matting agent which is most advantageously used in the present invention is crystalline or non-crystalline silica. These can be used alone by combining at least two kinds thereof. Grain size of the above-mentioned matting agent is preferably 1 - 10 microm on average, more preferably 2 - 7 microm. The coating amount of matting agent is 0.021 - 0.1 g/m², preferably 0.025 - 0.08 g/m².

Moreover, it is preferable to add a high boiling point organic solvent to the surface layer. As preferable high boiling point organic solvent to be added to the surface layer, those having vapor pressure of not more than 0.5 mmHg at 100 °C is preferable. A compound having dielectric constant of not more than 6.0 is more preferable. As specific examples of compound, those ones which are referred to concerning dispersion of the above-mentioned dye-forming coupler can be cited. The addition amount is generally in the range of 1 to 100 mg/m² and, more preferably, 10 to 50 mg/m².

To the light-sensitive material of the present invention, for the purpose of improving various physical surface properties such as adhesion, stickiness, Sliding property and anti-abrasion property, surfactants containing fluorine atoms or organopolysiloxane can be added. As for preferable surfactants containing fluorine atoms, those compounds represented by formulas (I), (II) and (III) disclosed in Japanese Patent Application No. 4-270425(1992) can be mentioned. Among them especially preferable ones are Exemplified Compounds FI-55, FI-81, FK-5, FK-13, and FK-23. Preferable organopolysiloxanes are those represented by the general formulas (S1), (S2), (I), (II), and (III) disclosed in Japanese Patent Application No. 4-270425 issues (1992) can be mentioned. And, As especially preferable compounds, those shown by S-7 and S-19 can be cited.

In the present invention, It is preferable to use the oil-soluble dye. Herein the term "oil-soluble dye" means an organic dye whose solubility in water at 20° C is lower than 0.01, and the compound whose molar absorption coefficient at the maximum absorption wave length of 400 nm or longer is 20000 or more is preferable. As preferable compounds, those represented by formulas II and III disclosed in the lower left column page 6 through in the lower right column on page 7 of Japanese Patent O.P.I. Publication No. 2-842(1990) can be mentioned. Specifically, Exemplified Compounds No. 1 through No. 27 disclosed in the lower right column on page 8 through in the upper right column on page 9 of the same reference can be mentioned. Among these, Compounds No. 4 and No. 9 are especially preferable. Among them, compounds 4 and 9 are especially preferable. It is preferable for this oil-soluble dye to be incorporated in the non-light-sensitive layer in a quantity of 0.05 - 5 mg/m².

In the present invention, it is preferable to add a fluorescent brightening agent into the light-sensitive material. As the fluorescent brightening agent, the compound represented by formula II disclosed in Japanese Patent O.P.I. Publication No. 2-232652 (1990) is preferable. As more specific compounds, exemplified Compounds 1 through 6 disclosed in the lower left column on page 6 through upper right column on page 7 of the same can be mentioned.

It is preferable that these fluorescent brightening agents are added to a non-light-sensitive layer. As addition amount, the range between 0.001 and 0.3 mg/m² is generally preferable and 0.1 to 0.2 mg/m² is more preferable.

In the present invention, it is preferable to supplement with the above-mentioned fluorescent brightening agent and to add a water-soluble polymer compound which is capable of improving the effect of the fluorescent brightening agent.

The polymer which comprises a polyvinyl pyrrolidone or a vinyl pyrrolidone as a repeating unit can be mentioned as a preferable compound. It is preferable that these are incorporated in a UV absorbent-containing layer, which is located in the farthest position from the support or in a layer which is located still farther therefrom.

In the light-sensitive color photographic material of the present invention, it is preferable to use a water soluble dye which has absorption in various wave length regions for the purpose of preventing irradiation or halation. As especially preferable anti-irradiation dyes, are cited compounds represented by the general formula II disclosed in Japanese Patent O.P.I. Publication No. 62-253164(1987), more specifically, exemplified Compounds II-1 through II-19 disclosed in the upper right column on page 12 through in the lower left column on page 13 of the same; compounds represented by the general formula I disclosed in Japanese Patent O.P.I. Publication No. 64-26850(1989),more specifically, exemplified Compounds No. 1 through No. 85; compound represented by the general formula I disclosed in Japanese Patent O.P.I. Publication No. 2-07040(1990), more specifically, exemplified Compounds No. 1 through No. 103; compounds disclosed at the 22nd line on page 3 through at the second line on page 5 of Japanese Patent Application No. 4-182885 (1992) can be mentioned. Among these compounds, especially preferable compounds are Compound No. 47, which is represented by the general formula I disclosed in Japanese Patent O.P.I. Publication No. 64-26850(1989), Compound No. 54, which is represented by the general formula I disclosed in Japanese Patent O.P.I. Publication No. 2-97940(1990) and Compounds 1, 4,6,7 and 9 disclosed in Japanese Patent Application No. 4-18288(1992).

It is preferable to use with a combination of anti-irradiation dyes which has an absorption maximum in the wave length regions between 600 and 700nm, a dye which has a maximum absorption in the wave length region between 500 and 600nm, and between 400 and 500nm.

These dyes can be incorporated in any one of layers, however, it is preferable to add to a non-light-sensitive layer. As an addition amount, it is 1 - 100 mg/m² for each compound.

Various apparatus and methods well-known in the art, can be employed for the preparation of the silver halide emulsion.

The silver halide emulsion to be used in the present invention can be anyone that is obtained in either one of an acid a neutral and ammoniacal method and the silver halide grains contained in the emulsion may be either one which have been grown at a time or one which has been grown after from seed grains. As for the method of preparing the seed grain and for the growth thereof, it may be either the same or different.

As for the manner of reacting a soluble silver salt with a soluble halide, either one of mixing process, i.e., normal mixing method, reverse mixing method, a simultaneous double-jet mixing method or any combination thereof, can be employed. Among them, the double-jet method is preferable. Also, a pAg-controlled double-jet mixing method disclosed in Japanese Patent O.P.I. Publication No. 54-48521(1979) may be used.

Moreover, an apparatus in which the water-soluble silver salt and the water-soluble halide are supplied from an apparatus arranged in the reaction solution, as disclosed in Japanese Patent O.P.I. Publications No. 57-92523(1982), No. 57-92524(1982), etc., an apparatus, whereby the aqueous silver salt and the aqueous halide solutions are added continuously while changing concentrations thereof, as disclosed in German Patent O.P.I. Publication No. 2921164 and an apparatus, in which grain formation is carried out while maintaining the distances between silver halide grains, by concentrating density of silver halide crystal by ultrafiltration, can also be used.

A solvent for the silver halide such as thioether can be used when it is necessary. Moreover, a compound having a mercapto group, a nitrogen-containing heterocyclic compound or a spectral sensitizing dye compound can be added either during the formation of silver halide grains or after completion of the formation of the grains.

From the silver halide emulsion which comprising silver halide grains, unnecessary soluble salts may be removed after completion of the growth of the silver halide grain. The removal of the salts may be carried out, for example, in accordance with the method disclosed in Research Disclosure No. 17643.

The shape of the silver halide grains used in the present invention may be optional. One preferable example is cubic grains of which surfaces consist of [100] planes. Moreover, the grains having octahedral, tetradecahedral or dodecahedral shape, etc can be produced and used in accordance with the methods disclosed in U.S. Patents No. 4,183,756, and No. 4,225,666; Japanese Patent O.P.I. Publications No. 55-26589(1980), and Japanese Patent publication No. 55-42737(1980); Journal of Photographic Science (J. Phot. Sci.) on page 39, (1973) etc. can be used. Furthermore, grains having a twin plane can also be used.

The silver halide grains of the invention may be comprised of a single-formed grains or a mixture of various-formed grains.

There is no specific limitation as to the grain size of the silver halide crystal, however, in view of other photographic properties such as rapid processability and sensitivity, it is preferably in the range of 0.1 to 1.6 µm and, more preferably, 0.2 to 1.2 µm.

In the case where the grains have a uniform shape, distribution of the grain size can be expressed precisely in terms of diameter or projection area of the silver halide crystal grains. The size-distribution of the silver halide grains may be either so-called "poly-dispersion" or " mono-dispersion. Preferably, it is "mono-dispersion with a coefficient of variation of the size-distribution being not more than 0.22 and, more preferably, not more than 0.15.

Herein the term "coefficient of variation" is defined in terms of the following equation:$\text{Coefficient of Variation = S/R}$
wherein S represents standard deviation of the grain size distribution, and R, average diameter of the grain.

The diameter of the grain represents its diameter when the grain has a spherical shape, and in the case where the shape of the grain is other than spherical, it represents the diameter of the circle equivalent to the projection area thereof.

The silver halide emulsion used in the present invention is one selected from the group consisting of silver iodobromide, silver iodobromochloride, silver bromochloride, silver bromide and silver chloride. Preferably, it is either silver chloride or silver bromochloride of which silver chloride content is not less than 90 mol% and which is substantially free of silver iodide, and this means that the silver iodide content of the silver halide crystal is less than 0.5 mol%, more preferably, not more than 0.1 mol% and ,most advantageously, it does not contain any silver iodide at all. Further, silver chloride content of the silver halide grain is not less than 95 mol%, more preferably not less than 98 mol% and, most advantageously not less than 99 mol%.

In the case where the silver halide crystal is silver chlorobromide containing silver bromide, it may be either so-called a "core/shell" grain, in which silver halide composition is different within the grain, or it may be one in which it has localized silver bromide phase inside. However, is preferable silver halide grains having a uniform composition from the inside to the surface thereof.

The silver halide emulsion used in the present invention can incorporate a variety of metal salts or metal complexes during the steps of formation of the grains or physical ripening thereof.

As such metals to be used, one listed in VIB, VIIB, VIIIB, IIB, IIIA and IVA families in the periodical table of the elements can be cited and among them, a preferable one is a salt or a complex of Mn, Fe, Co, Ni, Zn, Ga, Ge, Mo ,Ru, Pd, Cd, In, Sn, W, Re, Os, Ir, Pt, Tl, Zn and Au. Preferable salts and complexes are those disclosed in, for example, Japanese Patent O.P.I. Publications No. 4-125629(1992), No. 4-251469(1992) and No. 4-253081(1992).

Although the amount of addition of these compounds may be varied depending upon the kind of the compound or complex used or the object thereof, a range between 10⁻¹¹ and 10⁻¹³ mols per mol of the silver halide is preferable.

In the silver halide emulsion used in the present invention, gold sensitization with a gold compound, sulfur sensitization with a calcogenide sensitizing agent and a combination thereof can be applied.

As the gold sensaitizer, chloroauric acid, gold chloride and gold thiosulfate, and a complex thereof may be added.

Amount of addition of the gold sensitizer may vary depending on the kind of silver halide emulsion, kind of the gold compound, ripening conditions, etc., however, it is in the range between 1 x 10⁻⁹ and 1x10⁻⁴ mols per mol of silver halide and, more preferably, between 1x10⁻⁸ and 1x10⁻⁵ mols per mol of silver halide.

As for chalcogen sensitizers, for example, a sulfur sensitizer, a selenium sensitizer and a tellurium sensitizer are cited, and the sulfur sensitizer is preferable.

As sulfur compounds, thiosulfides, allylisothiocyanate, thioureas, systine, p-toluenesulfonates, rhodanine, inorganic sulfur, etc. can be cited.

The light-sensitive photographic material of the present invention may be subjected to a reduction sensitization. As to reduction sensitization, various methods are known in the art, including, for example, a method of adding a variety of reducing agents, a method of performing ripening at a high silver ion concentration, a method of performing ripening under high pH condition.

As the reducing agents used in the reduction sensitization, for example, a stannous salt such as stannous chloride, borates such as tri-t-butylamine borate, sulfate such as sodium sulfate, potassium sulfate, reductones such as ascorbic acid, thourea dioxide, etc. can be mentioned.

Among these compounds, preferable one includes thiourea dioxide, ascorbic acid and a derivative therefrom and sulfates. In comparison with the methods of controlling silver ion concentration or pH during ripening, the method of using reducing agents is more preferable in the light of its reproducibility.

These reducing agents are dissolved in a solvent such as water, alcohol, and are added to the silver halide emulsion to undergo ripening. Or they may be added to the emulsion at the time of crystal formation, and the reduction sensitization can be carried out during the time of crystal formation.

The amount of addition of these reducing compounds may be varied depending on pH and pAg of the silver halide emulsion. It is, generally, in the range between 10⁻⁷ and 10⁻² mols per mol of silver halide emulsion.

For the purpose of modifying reduction sensitization specks or deactivating the remaining recducing agents, a small amount of oxidizing agent may be used. And as for such oxidizing agent used for this purpose, potassium ferrihexacyanate, bromosuccinic imide, p-quinone, potassium perchloride, thiosulfinic acid, and aqueous solution of hydrogen peroxide can be mentioned.

During the step of sensitization, into the silver halide emulsion used in the present invention, can be incorporated a silver halide solvent. Preferable solvents, which are employed in the present invention include thiocyanate compounds, and, for example, potassium thiocyanate, sodium thiocyanate, calcium thiocyanate, magnecium thiocyanate, silver salts of thiocyanate, ammonium thiocyanate, etc.

There is no specific limitation as to pH or pAg during sensitization, and it is usually carried out under pH of 4.0 to 11.0, and pAg of 4.5 to 8.5.

To the silver halide emulsion used in the present invention, for the purpose of restraining fog, which usually takes place during manufacturing steps thereof, restricting fluctuation of the photographic properties during storage and preventing fog caused at the time of development, various anti-foggants or stabilizers, which are conventionally well known in the art can be applied.

As an example of compounds to be used for this purpose, compound represented by the following general formula [S] can be mentioned:

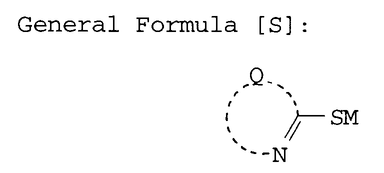

In the formula, Q represents a group of non-metal atoms necessary to form a five-membered or 6-membered nitrogen-containing heterocycle, and M represents a hydrogen atom or an alkali metal atom.

As for the 5-member heterocycle, for example, imidazole ring, tetrazole ring, thiazole ring, oxazole ring, selenazole ring,benzimidazole ring, naphthoimidazole ring, benzthiazole ring, naphthothiazole ring, benzselenazole ring,, naphthoselenazole ring, benzoxazole ring, etc. can be mentioned, and as for 6-member heterocycles represented by Q, pyridine ring, pyrimidine ring, quinoline ring, etc. can be mentioned. These 5- or 6- member heterocycles may have a substituent. As for the alkali metal atom represented by M, for example, sodium and potassium can be mentioned.

More advantageous structure of the mercapto compound represented by the formula [S] are disclosed in numbered paragraphs (0016) through (0032 of Japanese Patent Application No. 4-330655(1992).

Preferable structure of the mercapto compound is one represented by disclosed in the numbered paragraphs (0016 ) through(0032).

As more specific compounds, exemplified Compounds S-1-1 through S-4-8 can be mentioned.

Also compounds represented by the general formula[I] disclosed in to the numbered paragraphs (0026) through (0028) of the same reference, and ,more specifically, exemplified Compounds No1 through No. 49) can be mentioned as preferable examples.

As the spectral sensitization dye used in the silver halide emulsion of the present invention, any compounds well-known in the art can be applied.

As blue light-sensitive sensitizing dye Compounds BS-1 through BS-8 disclosed on pages 108 and 109 of Japanese Patent Application No. 2-51124(1990), either singly or in combination may be used.

As green light-sensitive sensitizing dye, Compounds GS-1 through GS-5 disclosed on page 110 of the same reference may preferably be used.

When the light-sensitive material of the present invention is subjected to light exposure by the use of a printer in which laser light source is installed, use of a sensitizing dye, which has light-sensitivity in the infrared region is necessary. As infrared light-sensitive sensitizing dye, exemplified Dyes IRS-1 through IRS-11 disclosed on pages 12 through - 14 of Japanese Patent Application No. 3-73619 (1991) can preferably be used. Moreover, compounds SS-1 through SS-9, which are disclosed on pages 14 through 15 of the same reference can be used together with these dyes as supersensitizing agents.

As laser printer equipments applicable in the invention, for instance, those disclosed in Japanese Patent O.P.I. Publication No. 55-4071(1980), Japanese Patent O.P.I. Publication No. 59-11062(1984), Japanese Patent O.P.I. Publication No. 63-197947(1988) and Japanese Patent O.P.I. Publication 2-74942(1990), Japanese Patent O.P.I. Publication 2-2236538(1990), Japanese Patent publication No. 56-14963(1981), Japanese Patent Publication No. 56-40822(1981), and European Patent 77410. 1984/6 (382),pp.: 34-36, No. 244, Vol. 80 volumes of synthesis and Electronic Communication Science Technique Research Report and Technique, Journal of Movie & Television, etc. can be mentioned.

As red-sensitive sensitizing dyes, those cyanine dyes represented by the following general formulae [2] and [3] can preferably be used.

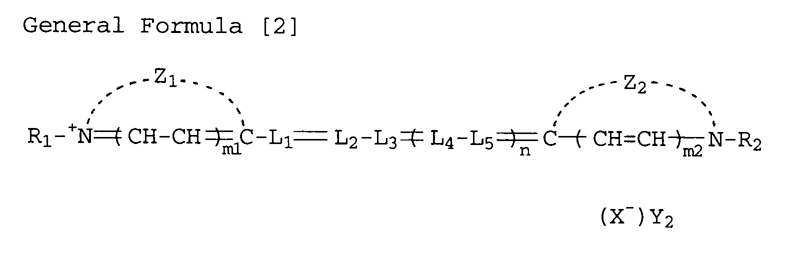

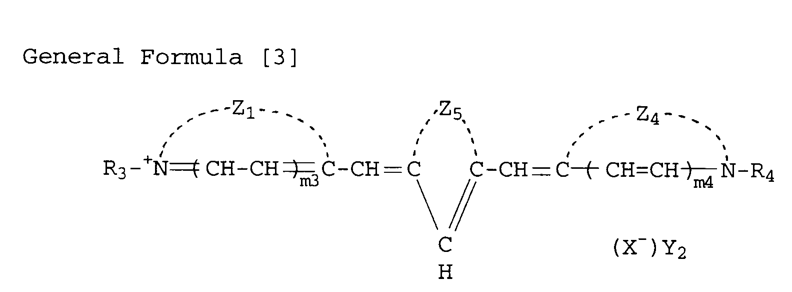

Wherein, R1, R2, R3, and R4 independently represent a group selected from the group consisting of an alkyl group, an alkenyl group and aryl groups; L1, L2, L3, L4, and L5 independently represent a methine group; Z1, Z2, Z3, and Z4 independently represent a group of atoms necessary to complete a 5-membered or 6-membered heterocyclic ring; Z5 represents a group of atoms necessary to form a 6-member carbon ring; m¹, m², m³, and m⁴ independently represent 0 or 1; n represents an integer of 0 or 1; X⁻ represents an acid anion, Y1 and Y2 independently represent an integer of 0 or 1, provided that when the compound forms an intra-molecular salt, Y1 and Y2 are 0.

As supersensitizating agent used for related silver halide emulsion used in the present invention, for example, stilbene, azaindene, mercapto-heterocyclic compound, condensation product of thiourea or, phenol and hexamethylenetetramine, etc. may be used. It is preferable to use a nine or more membered ring compound including a heterocyclic ring.

As the cyclic ring compound, from the viewpoint of effect is preferable one having an aliphatic ring and/or an aromatic ring and an ether linkage, and still more preferable is a macro-cyclic compound containing a an aromatic ring,

As typical examples, crown ether compounds can be mentioned, and, specific examples of these ring compounds are, for example, Compounds S-1 through S-39 disclosed in numbered paragraphs (0049 through (0055) of Japanese Patent O.P.I. Publication No. 6-175263(1994).

In the light-sensitive photographic material used in the present invention, it is advantageous to use gelatin as a binder for dispersion and coating solution.

As for the manufacturing methods of gelatin, for instance, description on page 55 of "The Theory of The Photographic Process 4th edition" edited by T.H.James (1977) and. "Basis of the Photographic Engineering-Silver Halide Photography", on pages 119 through 124 may be referred.

As raw material cattle bone (Ossein), Ox hide (Hide),or Pig-skin may be used, and, preferably, one prepared from the cattle bone. These gelatins may be mixed upon use.

As for the methods of treating the gelatin, alkaline treatment, acid treatment, oxygen treatment, etc. may be applied, and alkali treated gelatin is preferable.

The isoelectric point of the alkali-treated gelatin is preferably not less than 4.5 and, more preferably, not less than 5.

The gelatin can usually undergoes an ion-exchange treatment, and, in the present invention, gelatin which has undergone cathionic or anionic ion-exchange treatment or both can be applied depending on the objective.

Among Gelatins processed by cation, anion or both ionexchange in the present invention, optional one may be selected, however, in the present invention, gelatin which has undergone both ion exchange treatments is preferable.

Moreover, gelatin processed by hydrogen peroxide is also preferable.

Treatment of gelatin with hydrogen peroxide may be carried out in any step of the preparation of gelatin. For instance, It may directly be applied to ossein.

It may be done during alkali treatment or after that, or after extracting as a gelatin solution. In the present invention, is preferable gelatin, which is prepared by adding aqueous hydrogen peroxide solution during alkali treatment.

Hydrogen peroxide as pure H₂O₂ a kilogram of ossein is added in an amount within a range between 1 and 100g. It is preferable that the reaction with hydrogen peroxide is carried out under pH condition at 9.0 or below.

As composition of gelatin, one having fewer low molecular weight ingredient is preferable. In other words, one having more high molecule ingredient is preferable. As regards the method of Measurement of molecular weight of the lower and higher indredients of the gelatin, the method which is disclosed in the description at 15th line in the left down column on page 2 through at 8th line in the upper left column on page 3 of Japanese patent O.P.I. Publication No. 1-265247(1989) can be applied. It is preferable that the higher molecular weight ingredient is contained in an amount of not less than 30% by weight, and/or the lower molecular weight ingredient is not less than 40% by weight, and the preferable molecular weight of the gelatin is between 10,000 and 200,000.

The higher is the jelly strength of the gelatin, the more preferable. Especially, one having jelly strength of 250 or more is preferable.

The less is ion content, which are contained in the gelatin as an impurity, the more preferable. For instance, as for Calcium ion, for example, 5000 ppm or less and, more preferably, 2000 ppm or less is generally preferable. However, depending on the nature of the emulsion, calcium of a quantity between 4000 and 5000 ppm is preferable. As for heavy metal ions such as iron and copper, 500 ppm or less in total is generally preferable, and, more preferably, 10 ppm or less, as respective elements is more preferable.

Especially as regards iron ion, 5 ppm or less and, more preferably, 3 ppm or less is preferable.

The higher is a specific optical rotation of the gelatin, is the better.

Especially, 150° or more is preferable. In the case of the gelatin which is used in the uppermost layer, 210° or more is preferable.

As for the color of the gelatin, the less, is usually the better.

One having light transmittance at 420nm in the form of 10% by weight of aqueous gelatin solution is, generally 50% or more and, preferably, 60%, and more preferably, 70% or more.

In order to raise the transmittance of gelatin, appropriate selection of the raw material, hydrogen peroxide treatment, ion exchange treatment, or adsorption by the use of a chelating resin, etc. may optionally be applied.

The total amount of gelatin contained in the light-sensitive material of the present invention is generally 10.0 g/m² or less and, more preferably, 7.0 g/m² or less.

In view of physical properties and other photographic properties, although there is no specific limitation in the lower limit, 3.0 g/m² is generally preferable.

The amount of the gelatin is usually determined as the weight of gelatin containing 11.0% by weight of water measured according to the method described in PAGI method.

In the present invention, a hardener of the binder is used. As hardeners, vinyl sulfonate-type hardener and chloro triazine-type hardener are preferable. As vinyl sulfon type hardener, compounds disclosed in the upper right column on page 25 through the upper right column 13th line, page 27 of Japanese Patent O.P.I. Publication No. 61-249054(1986). These hardeners may be used in combination thereof. It can be added to any of layers. Being used for the binder 0.1-10% by weight is preferable.

In the present invention, anti-molding agent may be added to anyone of the layers.

As for the reflective support used in the present invention, any material which is known and used in the art can be used, including white pigment-containing polyethylene coated paper, baryta paper, Vinyl chloride sheet. Polypropylene which comprises white pigments, polyethylene terephthalate support, etc.. Among these, a support which has polyolefin resin layer containing the white pigment on the surface is preferable.

The photographic light-sensitive material of the present invention is subject to exposure, based upon color-separated halftone image information consisting of color separated yellow image information, magenta image information, cyan image information and black image information.

The exposure may be carried out by closely contacting the light-sensitive material with a halftone original, or from digitalized halftone image information with the use of a laser printing equipment.

An aromatic primary amine developing agent can be used in present invention.

The example of typical compounds are shown below.
- CD-1:: N,N-diethyl-p-phenylenediamine
- CD-2:: 2 -Amino-5-diethylaminotoluene
- CD-3:: 2-Amino- 5-(N-ethyl- N-laurylamino)toluene
- CD-4:: 4-(N-ethyl-N-β-(hydroxyethylamino)aniline
- CD-5:: 2 -Methyl-4- N-ethyl-N-(β-hydroxyethylamino)aniline
- CD-6:: 4-amino-3-methyl-N-ethyl-N-(β-methanesulfonamidoethyl)aniline
- CD-7:: N-(2-amino-5-diethylaminophenylethyl) methane sulfonamide
- CD-8:: N,N- dimethyl p-phenylenediamine
- CD-9:: 4-amino-3-methyl-N-methoxyethylaniline
- CD-10:: 4-amino-3-methyl-N-ethyl-N-(β-ethoxyethyl)aniline
- CD-11:: 4-amino-3-methyl-N-ethyl-N-(β-butoxyethyl)aniline
- CD-12:: 4-(n-ethyl-N-(β-hydroxypropylamino)aniline

These color developing agents can be used either singly or together with one or more kinds of well-known p-phenylenediamine derivatives.

A color developing agent is usually used within a range between 1 x 10⁻² and 2 x 10⁻¹ mols per liter of developing solution. In the light of rapid processing, it is preferably used within a range between 1.5 x 10⁻² and 2 x 10⁻¹ mols a liter of color developing solution.

As color developing agent used in present invention CD-4, CD-5, CD-6, and CD-9 are preferable, and, especially, CD-4 is preferable to approximate the produced dye close to the image tone of the printing ink.

These p-phenylenediamine derivatives are usually used in the form of an acid salt such as sulfate, hydrochloride, sulfite, nitrate, and p-toluenesulfonate.

According to one of preferable embodiments of the present invention, it is preferable that the developing solution used in the present invention does not substantially contain benzyl alcohol. Herein the term "developing solution does not substantially contain benzylalcohol" means that it contains, if any, less than 2 ml per liter of the developing solution. Most advantageously ion the present invention the developing solution does not contain any bebzylalcohol at all.

In the color developing solution used in the present invention, in addition to those mentioned above, various other developer ingredients, for instance, alkali agents, such as sodium hydroxide, potassium hydroxide, sodium meta borate, sodium, potassium metaborate, tri-sodium phosphonate, trisodium, phosphonate, tri-potassium, borate and silicate, etc. can be used either singly or in combination with other additive, within the range where precipitation does not takes place and the effect of the pH stabilization is maintained: Furthermore, if necessary or for the purpose of enhancing ion strength, dihydrosodium phosphate, dipotassium phosphate, sodium metacarbonate, potassium metacarbonate, Borate, etc. can be used.

In the present invention, it is preferable that the color developing solution contains chloride at a quantity of 2.5 x 10⁻²/5 x 10⁻¹ mols/liter. And, as for the bromide ion, at 2.0 x 10⁻⁵/2.0 x 10⁻² mol/liter.

Herein, the chloride ion and the bromide ion can be directly incorporated in the developer, or those ions, which may be dissolved from the light-sensitive material into the developing solution during the photographic process, may also be used.

In the case where the they are directly added to the color developing solution. As chloride ion supplying substance, for instance, sodium chloride, potassium chloride, ammonium chloride, lithium chloride, nickel chloride, magnesium chloride, manganese chloride, calcium chloride, cadmium chloride, etc. can be mentioned.

Among these, sodium chloride and potassium chloride, are preferable. Also, they may be supplied from the fluorescent brightening agent incorporated in the developing solution.

As bromide ion-supplying substance, for example, sodium bromide, potassium bromide, ammonium bromide, Lithium bromide, nickel bromide. Magnesium bromide, manganese bromide, calcium bromide, cadmium bromide, cerium bromide, Thallium bromide, can be mentioned. Among these, sodium bromide and potassium bromide are preferable. Also, it may be supplied from the fluorescent brightening agent incorporated in the developing solution.

In the color developing solution, in place of hydroxyl amine, which has been used as a preservative, hydroxylamine derivatives disclosed in Japanese Patent O.P.I. Publications No. 63-146043(1988), No. 63-146042(1988), No. 63-146041 (1988), No. 63-146040(1988), No. 63-135938(1988), No. 63-118748(1988) and No. 63-179351(1988); hydroxyl amine derivatives dislosed in Japanese Patent O.P.I. Publication No. 63-179351(1988);and hydroxamic acids, hydrazines, hydrazides, phenols, α-hydroxyketones, α-aminoketones, succharides, monoamines, diamines, quoternary ammonium salts, nitroxyl radicals, alcohols, oxims, diamides, fused cyclic amines, etc, disclosed in Japanese Patent O.P.I. Publication No. 1-103438(1989), etc. can preferably be used as organic preservatives.

These compounds may be used together with hydroxyl amines used heretofore and the above-mentioned organic preservatives, however, in the light of developability.

It is more preferable not to use a hydroxylamine compound.

It is also possible to use, if necessary, a development accelerator. As for such development accelerator, various kinds of pyridinium compounds and other cationic compounds, disclosed in U.S. Patents No. 2,648,604 and No. 3,671,247, and Japanese Patent Publication No. 44-9503(1969); cathionic dyes such as phenosafranine; neutral acids such as thallium nitrate polyethyleneglycol and derivatives thereof disclosed in U.S. Patents No. 2,533,990, No. 2,531,832, No. 2,950,970, and No. 2,577,127, and Japanese Patent Publication No. 44-9509(1069); nonionic compounds such as polythioether; organic solvents and organic amines disclosed in Japanese Patent Publication No. 44-9504(1969) ;ethanol amines, ethylenediamines, diethanolamines, triethanol- amines, etc. can be mentioned, Still further, if necessary, as solubilizing agents such as ethyleneglycol, methylcellosolve, methanol, acetone, dimethylformamide, β-cyclodextrine, p-toluene sulfonate, preservatives selected from these compounds and other compounds disclosed in Japanese Patent Publications No. 47-33378(1972) and No. 44-9509((1969) may also be used.

Still further, if necessary, auxiliary developer may be used together with the main developing agent. As such auxiliary developing agents, for example, N-methyl-p-aminophenol sulfate, phenidone, N,N-diethyl-p-aminophenol hydrochloride, N,N,N',N'-tetramethyl-p-phenylenediamine hydro chloride, etc. are well-known in the art, and, the quantity of addition is usually 0.01/1.0 g per liter of the developing solution. If necessary, various other additives such as competing couplers, fogging agents, development inhibitor releasing coupler or DIR couplers or development inhibitor releasing compounds, etc. may be added.

Other additives such as anti-staining agents, anti-sludging agents, and intra-layer effect accelerating agents can also be used.

The above-mentioned respective ingredients used in the color developing solution can be prepared by being dissolved in the predetermined amount of water beforehand, and, then, agitated.

Concentration of sulfite in the color developing agent is preferably lower than 1x10⁻² mols/liter, more preferably, lower than 7 x 10⁻³ mols/ liter and ,particularly, lower than 5 x 10⁻³mols/liter including nil.

In the present invention, the color developing solution can be used under optional pH level, however, in view of adaptability to rapid processing, preferable pH range is generally between 9.5 and 13.0, and, more advantageously, between 9.8 and 12.0.

The color developing temperature is preferably between 25°C and 70°C. Although the higher is the temperature, the quicker the processing can generally be made, however, in view of the stability of the processing solution, it is preferable that the processing temperature is not too high. It is preferable for the processing to be carried out at a temperature of 25 to 50°C. Preferable processing time is necessarily be between 40 and 240 seconds. In the case where the processing time is shorter than 40 seconds, maximum density in the continuous processing tends to be unstable. In the case where the processing time is longer than 240 seconds, there is a defect that sludge is liable to be caused. Preferably, the processing period is from 45 to 220 seconds and more preferably, 90 to 220 seconds.

Replenishing amount of the color developing solution is preferably less than 700cc's a square meter of the light-sensitive material, which is to be processed and, more preferably, 20/280 ccs.

Processing step essentially consists of color developing step, bleach-fixing step and washing step, or stabilizing step in place of the washing step, and within the range where the final effects of the present invention are not jeopardised, another step or steps may be added;for example, the bleach-fixing process may be divided into two independent steps of bleaching step and fixing step or inserting a bleaching step before the bleach-fixing step.

According to preferable embodiment of the present invention, it is preferable to arrange a bleach-fixing process immediately subsequent to color developing process.

Although there is no specific limitation as to the bleaching agent, however, it preferably be a metal complex of an organic acid. Such metal complexes are preferably those in which an organic acid such as polycarboxylic acid, aminopolycarboxylic acid, oxalic acid or citric acid is cordinated with a metal ion such as iron, cobalt, cupper, etc.

As the most preferable organic acid, which is capable of forming a metal complex, polycarboxylic acids and aminopolycarboxylic acids can be mentioned. These polycarboxylic acids or aminopolycarboxylic acids may be in the form of an alkali metal salt, an ammonium salt or a water-soluble amine salt. As more specific examples of these compounds, for example, those compounds disclosed in the lower left column through lower right column on page 18 of Japanese Patent O.P.I. Publication No. 1-2051629(1989) can be mentioned.

These bleaching agents can be used in an amount of 5 to 450 g and, more preferably, 20 to 250 g per liter of bleach-fixing solution.

The bleach-fixing solution used for the present invention comprises a fixing agent of the silver halide in addition to the bleaching agent mentioned hereinbefore, and, if necessary, other solution containing a sulfate as the preservative may also be applied.

Moreover, other than the bleaching agent comprising ferric(III) ethylenediaminetetracetate and the fixing agent for the silver halide, a special bleach-fixing solution, to which a large quantity of halide compounds such as ammonium bromide is incorporated, may also be employed.

As for the halide compounds mentioned above, hydrochloric acid, hydrobromic acid, lithium bromide, sodium bromide, potassium bromide, sodium iodide, potassium iodide, ammonium iodide, etc. may also be used.

As for the fixing agent for the above-mentioned silver halide, which is contained in the bleach-fixing solution, those compounds which are used in the conventional fixing process and are, upon reaction with the silver halide, capable of forming a water-soluble complex, including, for example,, thiosulfates such as potassium thiosulfate, sodium thiosulfate, ammonium thiosulfate, etc,; thiocyanates such as potassium thiocyanate, sodium thiocyanate, ammonium thiocyanate, etc.; thioureas and thioethers can be mentioned as representatives.

These fixing agents are usually used in an amount of 5 g or more per liter of the bleach-fixing solution, and preferably 70 to 250 g. Herein, in the bleach-fixing solution, it is possible to add one or more kinds of pH buffers such as boric acid, sodium borate, sodium hydroxide, potassium hydroxide, sodium c carbonate, potassium carbonate, sodium metacarbonate, potassium metacarbonate, acetic acid, sodium acetate, ammonium hydroxide, etc.

In addition, a variety of other fluorescent brightening agents, anti-foaming agents or surfactants may also be incorporated.

Further, the bleach-fixing solution can comprise a preservative such as hydroxylamine, hydrazine, an addition product of bisulfate; organic chelating agents such as aminopolycarboxylic acids or stabilizers such as nitroalcohol, nitrates, etc.; organic solvents such as methanol, dimethylformamide, and dimethylnitroalcohol.

Still further, in the bleach-fixing solution, a variety of bleach-accelerators disclosed in, for example, Japanese Patent O.P.I. Publications No. 45-280(1971), No. 45-8506(1970), No. 46-556(1971), Belgian Patent No. 770,910, Japanese Patent Publication No. 45-8836(1970), No. 53-9854(1978), Japanese Patent O.P.I. Publication No. 54-71634(1979) and No. 49-42349(1974), etc. can be incorporated.

As to pH of the bleach-fixing solution, the solution is usually used at the pH of 4.0 or more, preferably in the range of 4.0 to 9.0, more preferably, 4.5 to 8.5 and, most preferably, 5.0 to 8.5.

The solution is used at the temperature below 80°C, and more preferably, below 55°C, while restricting evaporation. Processing time for bleach- fixing is preferably 240 seconds or shorter.

In the developing process applied to in the present invention, washing process is carried out subsequent to the color development step and bleach-fixing step.

Preferable embodiment of the washing process is explained hereinbelow:

As preferable compounds used in the washing solution, chelating agents, of which chelate stability constant with iron ion is not less than 8, can be mentioned. Herein, the term "chelate stability constant" means the constant, which is commonly known in the art and defined in, for example, "Stability Constant of Metal ion Complex", written by L.G.Sillen & A.E.Martell, published by Chemical Society, London in 1964 and in "Organic Sequestering Agents" written by S.Chaberek & A.E.Martell, published by Wiley in 1959. As for the chelating agents of which chelate stability constant is not less than 8, for example, iron complexes of organic carboxylic acid chelating agents, organic phosphoric acid chelating agents, inorganic phosphoric acid chelating agents, polyhydroxyl compounds, etc. can be mentioned. Herein, the term "iron ion" means ferric ion. As more specific examples of the compounds, of which chelate stability constant with ferric ion is not less than 8, those compounds disclosed in the 15th line in the lower right column on page 20 through 17th line in the lower left column on page 20 of Japanese Patent O.P.I. Publication No. 1-205162(1989) can be mentioned.

Preferable amount of addition of the above-mentioned chelating agent is generally between 0.01 and 50 g and, more preferably, between 0.05 and 20 g a liter of the rinsing solution. Further, as the compound which is added to the rinsing solution, ammonium compounds are especially preferable, and they are supplied in the form of an inorganic ammonium salt. More specifically, those compounds disclosed at 5th line in the upper right column on page 20 through 11th line in the lower left column on page 20 of Japanese Patent O.P.I. Publication No. 1-205162(1989) can be mentioned.

Preferable addition amount of the ammonium compounds is, generally, not less than 1.0 x 10⁻⁵ mol a liter of the rinsing solution. More preferably, it is between 0.001 and 5.0 mols and, especially preferably, between 0.002 and 1.0 mol a liter of the rinsing solution.

Still further, it is preferable for the rinsing solution to contain sulfite within the limits which do not cause generation of bacteria. Such sulfites which may be incorporated into the rinsing solution can be anyone, either organic or inorganic, so long as it is capable of releasing a sulfite ion. Preferably, it is an inorganic salt and, more specifically, sodium sulfite, potassium sulfite, ammo nium sulfite, ammonium bisulfite, potassium bisulfite, sodium bisulfite, sodium metabisulfite, potassium metabisulfite, ammonium metebisulfite, hydrosulfite, glutalaldehyde sodium bisulfite, sodium succinate aldehyde bisulfite, etc. can be mentioned.

It is preferable that the sulfite is contained in the rinsing solution at a quantity of at least 1.0 x 10⁻⁵ mol a liter of the rinsing solution and, more preferably, between 5 x 10⁻⁵ and 1.0 x 10⁻¹ mol. As for the method of addition, although it may be added to the rinsing solution directly, it is preferably added to a replenishing solution of the rinsing solution.

The rinsing solution used in the present invention preferably contains an anti-molding agent, and, thereby, improvement in anti-sulfidation and image stability can be accomplished. As such anti-molding agents, sorbic acid, benzoic acid-type compounds, phenolic compounds, thiazole-type compounds, pyridine-type compounds, guanidine-type compounds, morphorine-type compounds, quaternary phosphonium-type compounds, ammonium-type compounds, urea-type compounds, isoxazole-type compounds, propanolamine-type compounds, sulfamide-type compounds, pyronone-type compounds, amino-type compounds, etc. can be mentioned. As more specific compounds, those compounds disclosed at 10th line in the upper left column on page 21 through at 16th line, in the upper left column on page 22 of Japanese Patent O.P.I. Publication No. 1-205162(1989) can be mentioned. Among these compounds, those that are preferably used in the present invention are thiazole-type compounds, sulfamide-type compounds and pyronone-type compounds.

Preferable amount of addition of the anti-molding agent to the rinsing solution is, generally, 0.001 to 30 g a liter of the rinsing solution and, more preferably, 0.003 to 5 g. The rinsing solution used in the present invention preferably contains a metallic compound together with the chelating agent. Such metallic compounds include compounds of Ba, Ca, Ce, Co. In, La, Mn, Ni, Bi, Pb, Sn, Zn, Ti, Zr, Mg, Al, and Sr.

These metallic compounds may be supplied in the form of an organic or inorganic salt such as halide, sulfide, carbonate, phosphate, acetate,; hydroxide or water-soluble chelating agent.

As for the preferable amount of addition of these compounds, it is, generally, between 1.0 x10⁻⁴ and 1.0 x 10⁻¹ and, more preferably, 4.0 x 10⁻⁴ and 2.0 x 10⁻² mols a liter of the rinsing solution.

As other compounds, which may be incorporated in the rinsing solution, a compound having in the molecule a aldehyde group can be mentioned. More specifically, Exemplified Compounds No. 1/32 disclosed in the upper right column through lower right column on page 22 of Japanese Patent O.P.I. Publication No. 1-205162(1989) can be mentioned.

The compound having the aldehyde group may preferably used at a quantity between 0.1 and 50 g and, more preferably, between 0.5 and 10 g a liter of the rinsing solution.

Moreover, in the rinsing bath used in the present invention, ion exchanged water treated with an ion exchanging resin may also be used.

pH value of the rinsing solution is between 5.5 and 10.0. For the purpose of adjusting pH of the solution, any alkaline agent or acidic agent may be used.

Preferable temperature of the rinsing process is, generally 15 to 60°C and, more preferably, 20 to 45°C. Moreover, preferable processing time of the rinsing process is preferably less than 240 seconds. When the rinsing process is carried out using plurality of tanks, it is preferable that the longer processing time be taken in the process in the tank arranged in the backward. It is preferable that the rinsing process be carried out in sequence taking 20/50% longer time than that taken in the prior tank.

As to the manner of supplying the washing solution in the rinsing process step in the case of counterflow current method using a plurality of tanks, it is preferable for the water to be supplied to a posterior tank and then is overflown into anterior tanks. Of course, it is possible for the rinsing process to be carried out with a single tank.

Volume of water used in the rinsing process in the present invention is 0.1 to 50 times as much as the amount of carried-in bleach-fixing solution or fixing solution for a unit area of the light-sensitive material, and, especially, 0.5-30 times is preferable. One to five tanks are preferably used in the rinsing process and, more preferably, one to three tanks.

As to the apparatus and the quipment used for processing the light-sensitive material of the present invention, anyone that is well-known in the art can be used. To be more specific, it may be of a roller-transportation type, in which the light-sensitive material is placed and is transported between rollers arranged in the processing tank. It can be an endless belt transportation mode, in which the light-sensitive material is fixed to the belt and is transported. Besides these, a method in which the processing bath is formed in the form of a slit and the light-sensitive material is transported, while supplying the processing bath with the processing solution; a method in which the processing liquid is sprayed over the light-sensitive material; a web transportation method, in which the light-sensitive material is processed by contact with a support into which the processing solution is soak and a method of using viscous processing solutions may also be employed.

In the present invention, the effect of the invention is distinguishably exerted when a large quantity of light-sensitive material is processed continuously using the color developing through drying processes, and dissolution of ingredients from the light-sensitive material into the processing solution contamination between the processing baths and evaporation from the processing bath are saturated and become constant.

### Example

Hereinbelow the present invention is further explained with reference to working examples. However, of course, the scope of the present invention is not limited thereto.

### [Example 1]

On a 130 µm thick support, which comprises a paper substrate and provided on one surface of which is laminated with polyethylene and the other with polyethylene containing titanium oxide, were provided the following layers to prepare a multi-layer silver halide light-sensitive color photographic material.

### Coating composition for the first layer:

60cc of ethylacetate was added to 26.7 g of yellow dye-forming coupler (Y-1), 0.67 g of anti-staining agent (HQ-1) and 6.67 g of high boiling point organic solvent (HBS-1) to dissolve them. This solution was added to 220 cc of a 10% aqueous gelatin solution containing 7 cc of surfactant (SU-1) and dispersed by the use of an ultrasonic homogenizer to prepare a dispersion of a yellow-dye-forming coupler. This coupler dispersion was then mixed with a blue light-sensitive silver halide emulsion under the following condition, to prepare a coating solution for the first layer. Coating solutions for the second through the seventh layers were prepared in the similar manner.

Moreover, (H-1) was added to the second layer and the fourth layer as a hardener and (H-2) was added to the seventh layer. As coating aid, surfactant (SU-2) and (SU-3) were added to adjust the surface tension.

### Seventh layer (Protective Layer)

| | |
|---|---|
| Gelatin | 1.00 (g/m²) |
| Antistaining agent (HQ-1) | 0.002 |
| Antistaining agent (HQ-2) | 0.002 |
| Antistaining agent (HQ-3) | 0.004 |
| Antistaining agent (HQ-4) | 0.002 |
| Compounds B, C, D and E | 2x10⁻⁵ (each) |
| DIDP | 0.005 |
| Silica dioxide | 0.003 |
| Aiti-molding agent (F-1) | 0.002 |

### The sixth layer (UV-ray absorbing layer)

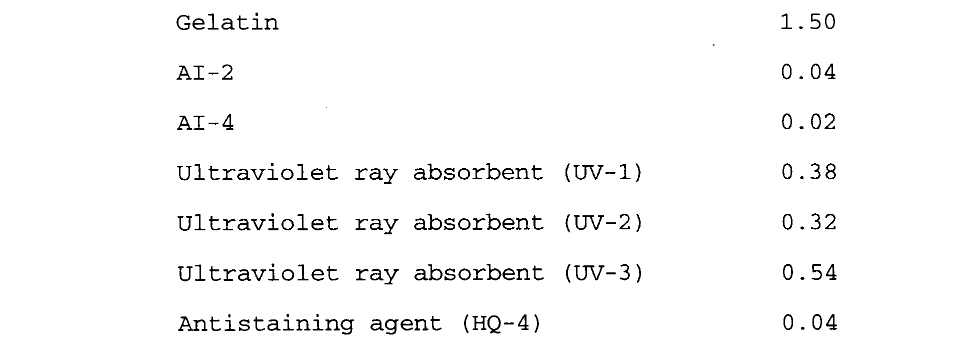

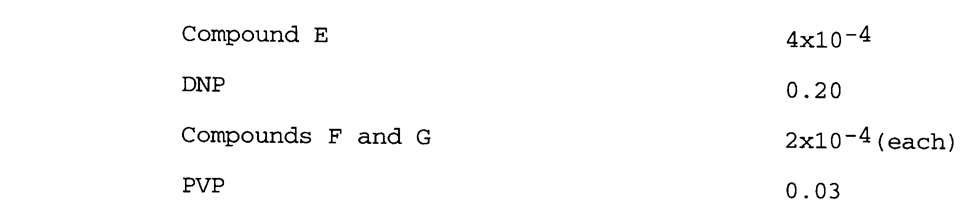

### Fifth layer (Red-sensitive layer)

| | |
|---|---|
| Gelatin | 1.3 |
| Red-sensitive silver chlorobromide emulsion (Em-R) | 0.36 |
| Cyan dye-forming coupler (C-1) | 0.30 |
| Anti-staining agent (HQ-5) | 0.01 |
| HBS-1 | 0.20 |

### Fourth layer (Interlayer)

| | |
|---|---|
| Gelatin | 1.00 |
| Anti-staining agent (HQ-1) | 0.01 |
| Antistaining agent (HQ-2) | 0.01 |
| Antistaining agent (HQ-3) | 0.02 |
| Antistaining agent (HQ-4) | 0.10 |
| Compounds B, C, D, and E | 2x10-5 (each) |
| DIDP | 0.03 |
| Anti-molding agent(F-1) | 0.02 |

### The third layer (Green-sensitive layer)

| | |
|---|---|
| Gelatin | 1.20 |
| Green-sensitive emulsion layer (Em-G) | 0.30 |
| Magenta dye-forming coupler (M-1) | 0.40 |
| Dye image stabilization agent | 0.20 |
| HBS-1 | 0.40 |

### Second layer (Interlayer)

| | |
|---|---|
| Gelatin | 1.00 |
| AI-1 | 0.20 |
| AI-3 | 0.20 |
| Anti-staining agent (HQ-1) | 0.03 |
| Antistaining agent (HQ-2) | 0.03 |
| Antistaining agent (HQ-3) | 0.05 |
| Antistaining agent (HQ-4) | 0.23 |
| Compounds B, C, D and E | 3x10⁻⁴ (each) |
| DIDP | 0.06 |
| Fluorescent brightening agent (W-1) | 0.10 |

### First layer (Blue-sensitive layer)

| | |
|---|---|
| Gelatin | 1.20 |
| Blue-sensitive silver chlorobromide emulsion (Em-B) | 0.28 |
| Yellow dye-forming coupler (Y-40) | 0.80 |
| Anti-staining agent (HQ-4) | 0.02 |
| Compound A | 2x10⁻⁴ |
| HBS-1 | 0.50 |

### Support

Polyethylene laminated paper (containing small amount of colorant)

In the above, the addition amount of silver halide emulsion was given in terms of converted weight of silver.
- SU-1:: Sodium naphthalene-tri-i-propyl sulfonate
- SU-2:: Sodium di-(2-ethylhexyl) sulfosuccinate
- SU-3:: Sodium (2,2,3,3,4,4,5,5-octafluoropentyl) sulfosuccinate
- DNP:: Dinonylphthalate
- DIDP:: Di-i-(decylphthalate
- PVP:: Polyvinyl pyrrolidone
- H-1:: Tetrakis(vinylsulfonylmethyl)methane
- H-2:: Sodium 2,4-dichloro-6-hydroxy-s-triazine

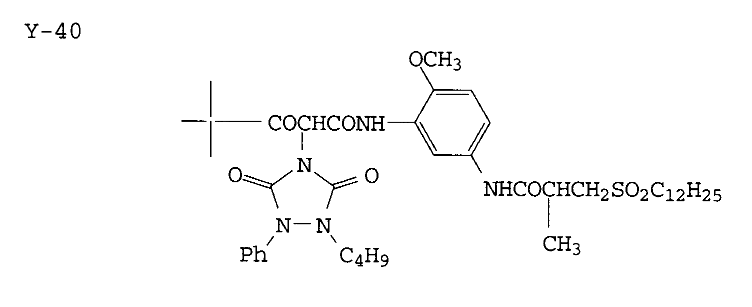

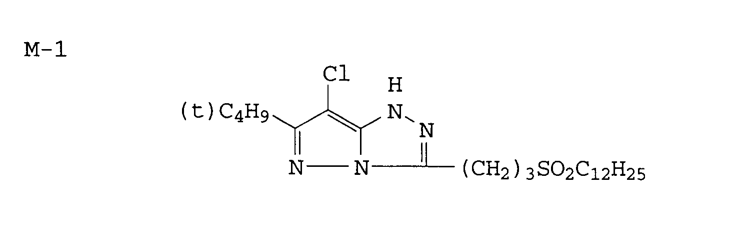

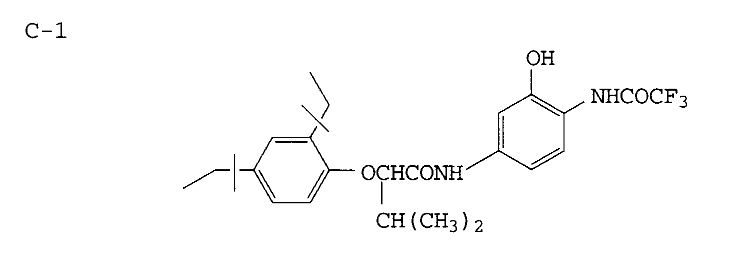

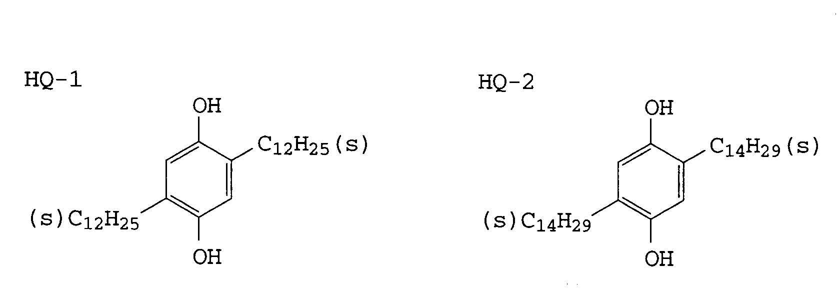

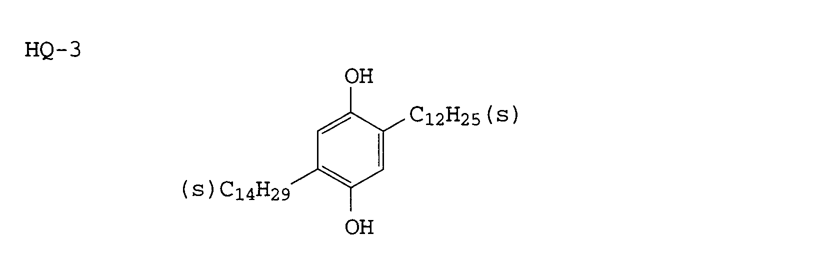

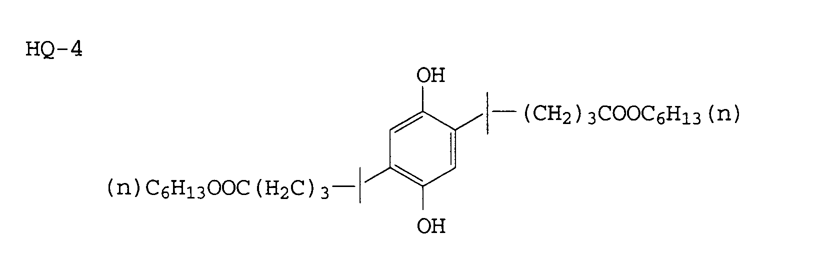

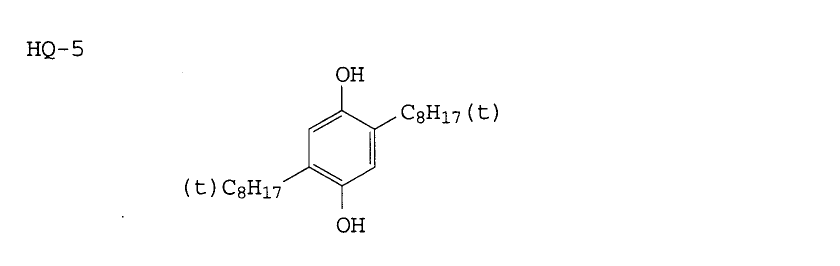

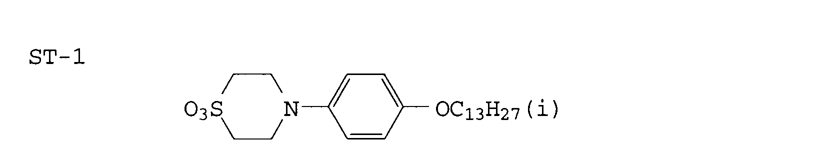

Compound A, B, C, D, E
(Quinones of HQ-5, 1, 2, 3 and 4, respectively) 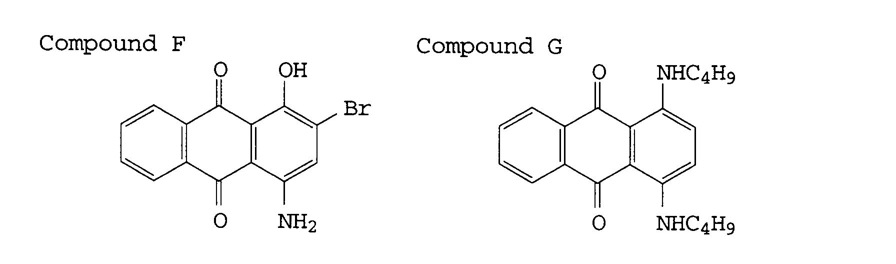
HBS-1

O=P- (C₈H₁₇)₃

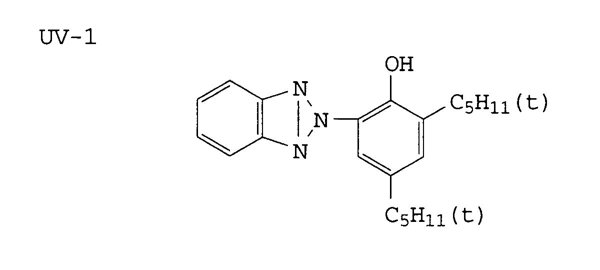

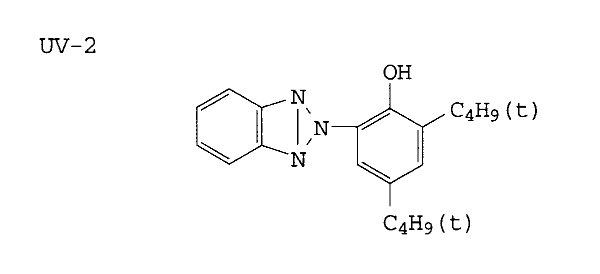

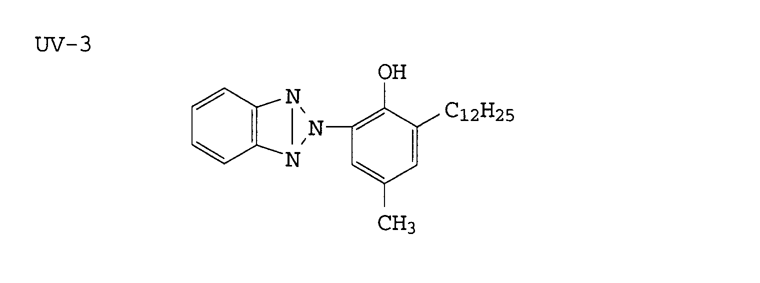

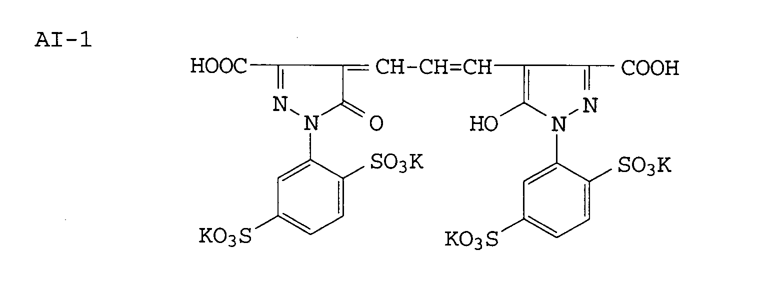

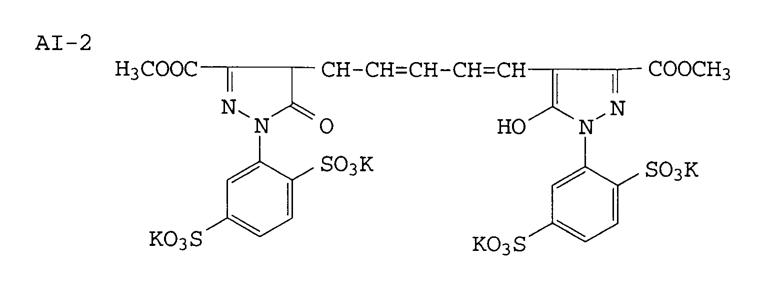

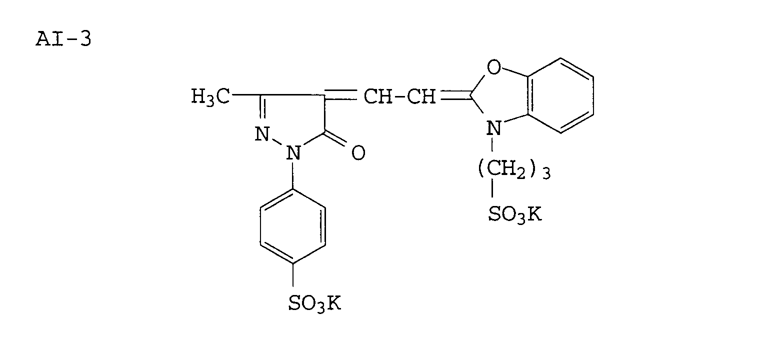

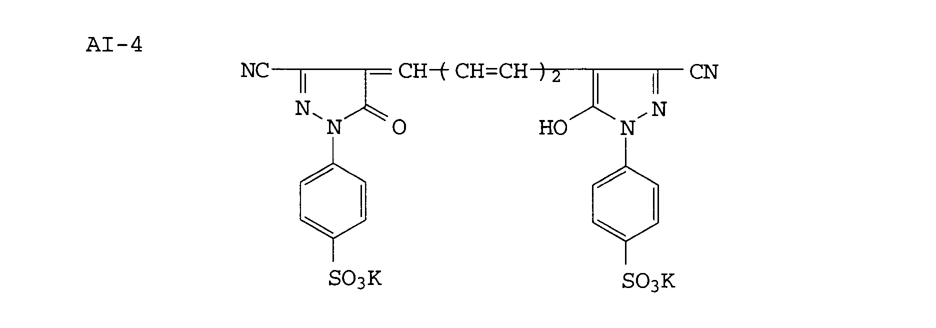

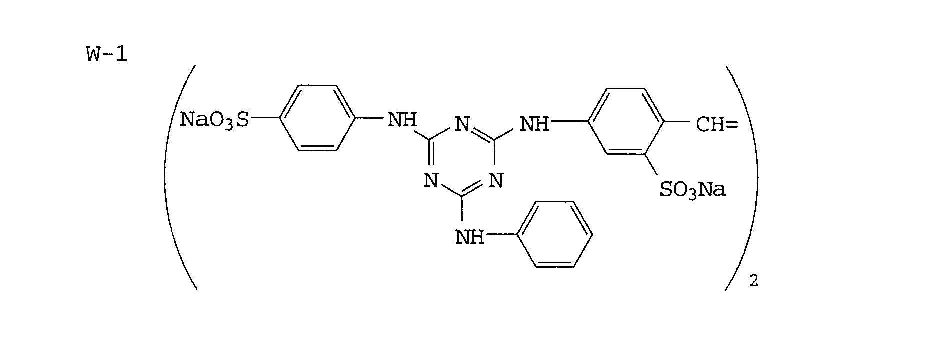

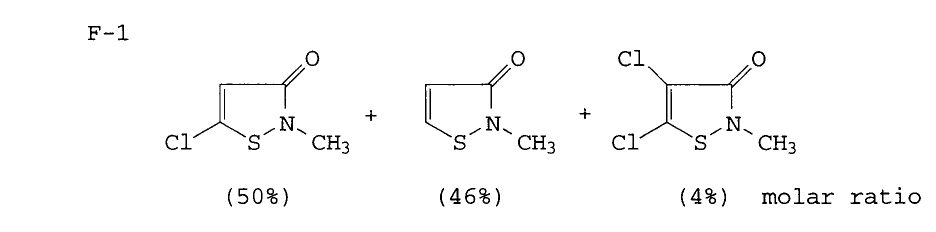

### (Preparation of a blue-sensitive silver halide emulsion)

Into two liters of a 2% aqueous gelatin solution, the following Solutions A and B were simultaneously added over 30 minutes, while pAg and pH of the solution were maintained at 8.0 and 3.0, respectively.

Then the following Solutions C and D were added simultaneously over 180 minutes, while the pAg and pH of the solution were maintained at 8.0 and 5.5, respectively. Herein, adjustment of pAg was made according to the disclosure in Japanese Patent O.P.I. Publication No,59-45437(1084) and the adjustment of pH was made using a aqueous sulfuric acid solution or an aqueous sodium hydroxide solution.

### (Solution A)

| | |
|---|---|
| Sodium chloride | 3.42 g |
| Potassium bromide | 0.03 g |
| Add water to make the total volume | 200cc |

### (Solution B)

| | |
|---|---|
| Silver nitrate | 10 g |
| Add water to make the total volume | 200cc |

### (Solution C)

| | |
|---|---|
| K₂IrCl₆ | 2x10⁻⁸ mol/mol Ag. |
| Sodium chloride | 102.7 g |
| K₄Fe(CN)₆ | 1x10⁻⁵ mol/mol Ag. |
| Potassium bromide | 1.0 g |
| Add water to make the total volume | 600cc |

### (Solution D)

| | |
|---|---|
| Silver nitrate | 300 g |
| Add water to make the total volume | 600cc |

After completion of addition, a 20% aqueous solution of magnesium sulfate, 5% aqueous solution of Demol N, product of Kao Atlas company, were added thereto to remove soluble salts. Subsequenty, by mixing with an aqueous gelatin solution, was prepared a monodispersed cubic crystal grain emulsion (EMP-1) having an average size of 0.85 µm, a variation coefficient of grain size distribution of 0.07 and a chloride content of 99.5 mol%. Emulsion EMP-1 was chemically sensitized optimumly at 60° C, using the following compounds. Thus, blue-sensitive silver halide emulsion (Em-B) for comparison was obtained.

| | |
|---|---|
| Sodium thiosulfate | 0.8 mg/mol AgX. |
| Chloroaurate | 0.5 mg/mol AgX. |
| Stabilizing agent STAB-3 | 8x10⁻⁴ mols/mol AgX. |
| Sensitizing dye BS-1 | 4x10⁻⁴ mols/mol AgX. |
| Sensitizing dye BS-2 | 1x10⁻⁴ mols/mol AgX. |

### (Preparation of green-sensitive silver halide emulsion)

A monodispersed cubic crystal grain emulsion EMP-2 having an average grain size of 0.43 µ, a variation coefficient of 0.08 and an chloride content of 99.5 mol% was prepared in the same manner as in EMP-1, except that addition times of Solutions A and B, and Solutions C and D were respectively varied.

Emulsion EMP-2 was chemically sensitized optimally at 55°C, using the following compounds to obtain a green-sensitive silver halide emulsion (EM-G).

| | |
|---|---|
| Sodium thiosulfate | 1.5 mg/mol AgX. |
| Chloroaurate | 1.0 mg/mol AgX. |
| Stabilizing agent STAB-1 | 6x10⁻⁴ mols/mol AgX. |
| Stabilizing agent STAB-2 | 3x10⁻⁴ mols/mol AgX. |
| Sensitizing dye GS-2 | 4x10⁻⁴ mols/mol AgX. |

### (Preparation of Red-sensitive silver halide emulsion)

A silver halide emulsion EMP-3,containing cubic-shaped mono-disperse silver halide grains, of which coefficient of variation, average grain size and silver chloride content are 0.08, 0.50 µm and 99.5 mol%, respectively, was prepared in the same manner as EMP-l,except that the time of addition of Solutions A and B, and Solutions C and D were varied.

Next, EMP-3 was chemically sensitized optimumly at 60°C, using the following compounds. Thus, a red-sensitive silver halide emulsion (Em-R) was obtained.

| | |
|---|---|
| Sodium thiosulfate | 1.8 mg/mol AgX. |
| Chloroaurate acid | 2.0 mg/mol AgX. |
| Stabilizing agent STAB-1 | 6x10⁻⁴/mol AgX. |
| Stabilizing agent STAB-2 | 3x10⁻⁴/mol AgX. |
| Sensitizing dye RS-1 | 1x10⁻⁴/mol AgX. |
| Super-sensitizing dye RSS-1 | 3x10⁻³/mol AgX. |

Sample 101 (comparison) was thus obtained.
- STAB-1:: 1-(3-acetamidephenyl)-5-mercaptotetrazole
- STAB-2:: 1-phenyl-5-mercaptotetrazole
- STAB-3:: 1-(4-(ethoxyphenyl)-5-mercaptotetrazole

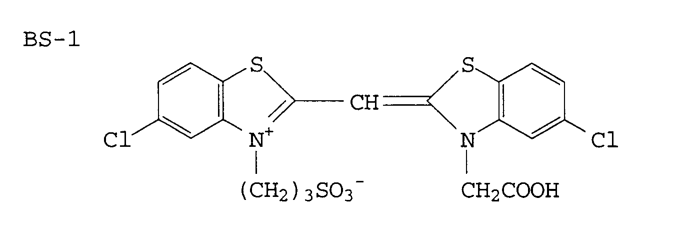

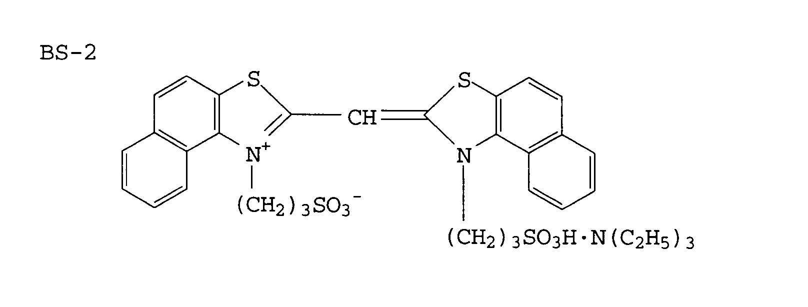

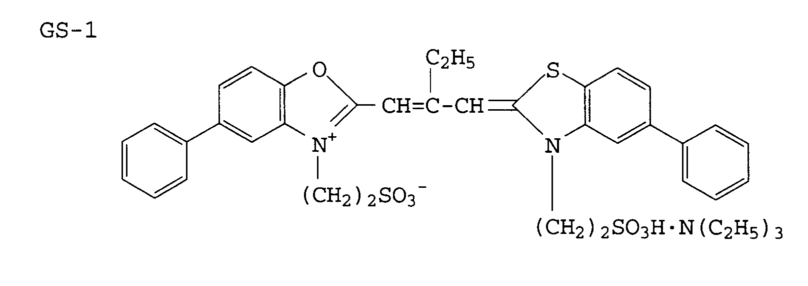

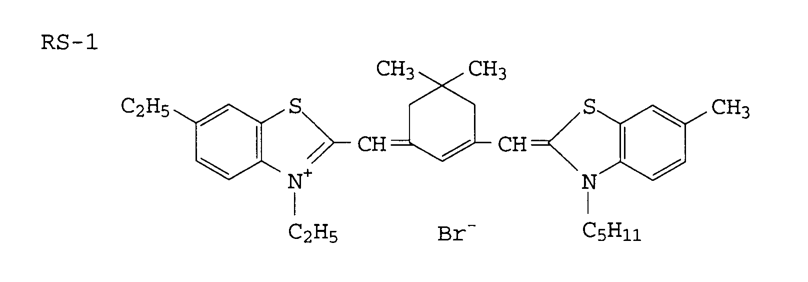

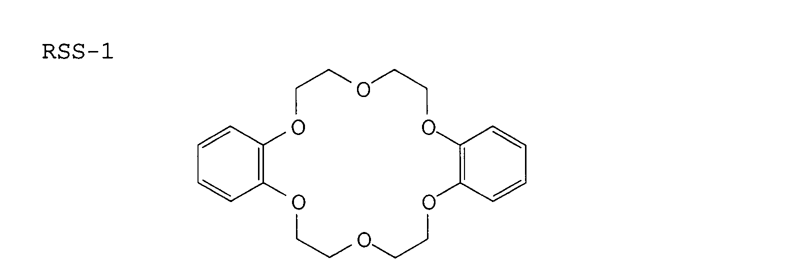

Samples 102 through 121 were prepared in the same manner as Sample 101, except that compounds as shown in Table 1 were varied.

Respective samples were exposed to light using fluorescent light, through Kodak Wratten Filter No. 61 and a magenta dot image original, and then were processed according to the following steps. Herein, an amount of exposure was adjusted so that the dot gain becomes that of a standard printing material, which is 20% in 50% dot image portion of the original. Further, samples of which dot gain is +3% was also prepared.

| Step | Temperature | Time | Replenishing Amount |
|---|---|---|---|
| Color Development | 37.0±0.3°C | 120 sec. | 300cc |
| Bleach-fixing | 35.0±0.5°C | 45 sec. | 300cc |
| Stabilization | 30-35°C | 90 sec. | 600cc |
| Drying | 50-80°C | 40 sec. | |

The composition of the photographic processing solutions are as follows:

### Color development tank solution and replenisher thereof

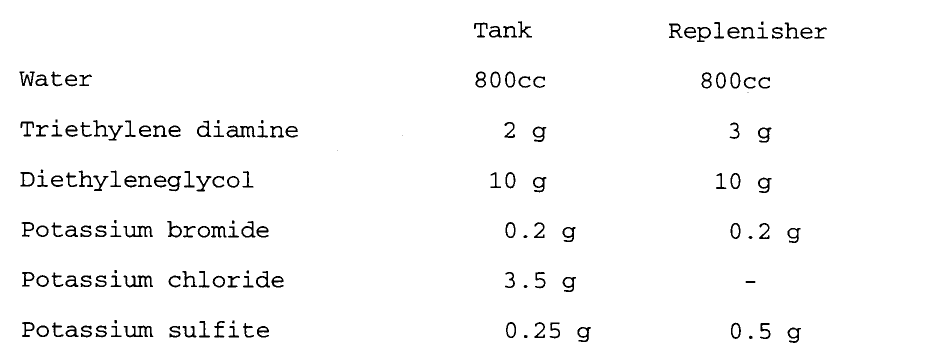

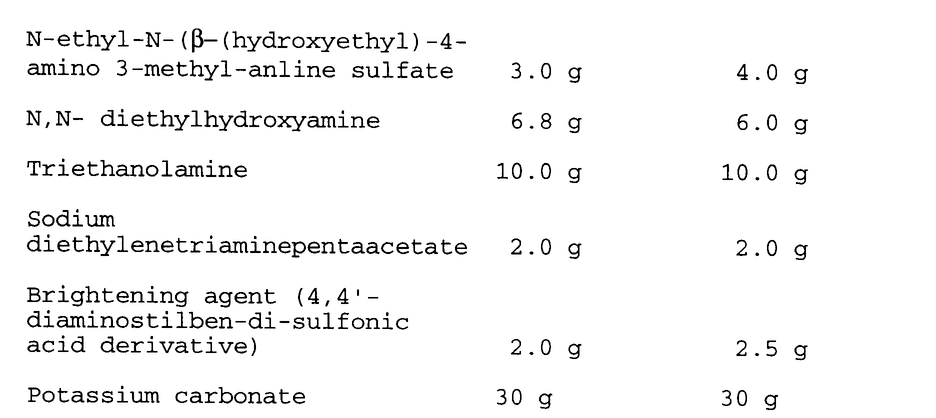

Water was added to make the total volume one liter, and was adjusted pH of the solution in the tank and in the replenisher to 10.10 and 10.42, respectively.

### Bleach-fixing tank solution and replenisher therefor:

| | |
|---|---|
| Ferric ammonium diethylenetriaminepentaacetate dihydrate | 65 g |
| Diethylenetriaminepentaacetate | 3 g |
| Ammonium thiosulfate (70% aqueous solution) | 100cc |
| 2-Amino-5-mercapto 1,3,4-thiadiazole | 2.0 g |
| Ammonium sulfate (40% aqueous solution) | 27.5cc |

Water was added to make the total volume one liter and was adjusted pH of the solution to 6.5 with potassium carbonate or glacial acetic acid.

### Stabilizing tank solution and replenisher thereof:

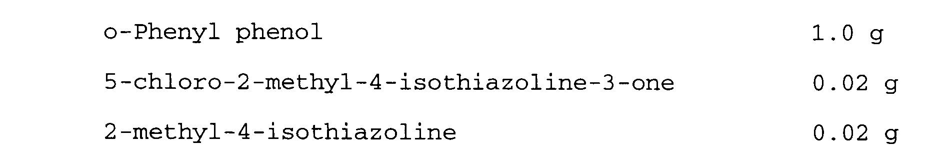

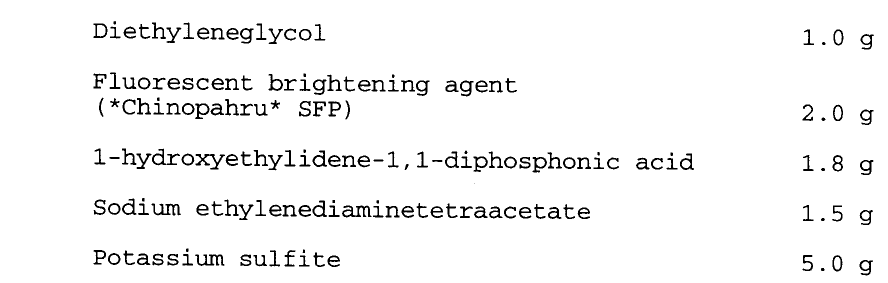

Water was added to make the total volume one liter and was adjusted pH of the solution to 8.0 with sulfric acid or ammoniacal water.

After subjecting to sensitometric exposure through an optical wedge and the photographic processing as mentioned above, the reflection densities of the samples were measured with PD-84 densitometer (produced by Konica Corporation).

The density of the solid portion of the samples, which were exposed through a dot image original, were measured using X-rite 408 densitometer, a product of X-rite Company, and color reproduction was evaluated by comparing color hue of a test sample with that of printed matter, using a Color Differential Colorimeter CRC-121, manufactured by Minolta Co., Ltd. The colorimetry data of the hue, thus obtained, was plotted on a L*a*b* chromaticity chart according to the standard of CIE or JIS Z-8727, and the differences in the positions of the hue on the a*b*-plane of the chromaticity chart between the test sample and the printed matter (i.e., color differential) was determined. Larger differences correspond to a larger variation in the color of the proof.

The dot gain was determined by calculation based on Malay-Davies equation.${\text{DG₅₀=[1-10}}^{\text{(Db-Dt)}} {\text{]/[1-10}}^{\text{(Db-D50)}} \text{] x 100-50}$
- DG₅₀:: Dot gain of 50% dot
- Db :: Density of white background
- D50 :: Density of 50% dot
- Dt :: Solid density

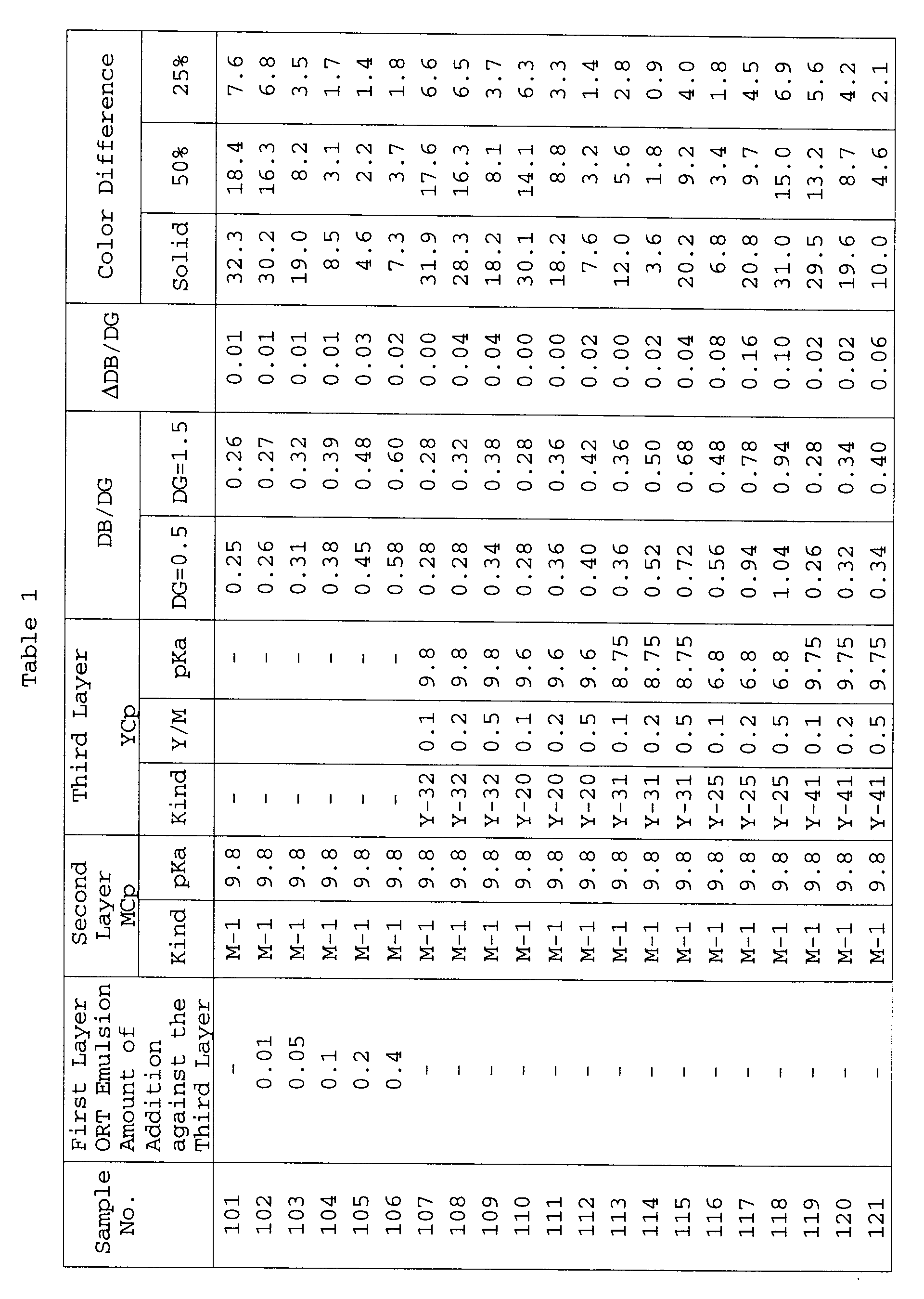

Density ratios (DB/DG) at densities (DG) of 0.5 and 1.5, and a difference between them (ΔDB/DG) are shown in the table. The color hue of the solid density, 25% dot and 50% dot portions were compared with that of the standard printed matter sample (color difference).

As shown in Table 1, it is understood that the photographic light-sensitive material prepared according to the present invention reproduced the color hue both in the solid density portion and in the dot image portions which was close to that of the standard printed matter.

### [Example 2]

Samples were prepared by providing a yellow dye-forming green-sensitive layer, of which composition is given below, between second and third layers of Sample 101 in Example 1.

### Intermediate Layer (Green-sensitive Layer)

| | |
|---|---|
| Gelatin | 0.40 (g/m²) |
| Green-sensitive silver chlorobromide emulsion (Em-G) | 0.060 |
| Yellow dye-forming coupler | 0.07 |
| HBS-1 | 0.07 |

As yellow-dye-forming couplers, Y-32, Y-20, Y-31, Y-25, Y-41, Y-40, or Y-42 was used to prepare samples and evaluation was made in the same manner as in Example 1. These were evaluated in the same manner as in example 1, so that the advantageous effects of the invention were achieved.

## Claims

1. A silver halide color photographic light-sensitive material comprising a support having thereon plural light-sensitive component layers including a blue light-sensitive layer containing a blue light-sensitive silver halide emulsion and a yellow coupler, a green light-sensitive layer containing a green light-sensitive silver halide emulsion and magenta coupler and a red light-sensitive layer containing a red light-sensitive silver halide emulsion and cyan coupler, wherein at least one of the light-sensitive component layers contains a silver halide emulsion containing silver halide grains having a chloride content of 80 mol% or more; density ratios of (DB₁/DG₁) and (DB₂/DG₂) are each within a range of 0.3 to 0.6, in which DG₁ is a green light density of 0.5, DB₁ is a blue light density when said photographic material is exposed to green light in an amount that gives said photographic material a green light density of 0.5, DG₂ is green light density of 1.5 and DB₂ is a blue light density when said photographic material is exposed to green light in an amount that gives said photographic material a green light density of 1.5.

2. The color photographic material of claim 1, wherein said green light-sensitive layer further contains a yellow coupler.

3. The color photographic material of claim 2, wherein a molar ratio of the yellow coupler to the magenta coupler is 0.02 to 0.5.

4. The color photographic material of claim 2, wherein pKa values of said magenta and yellow couplers contained in said green light-sensitive layer satisfy the following relation,$\text{0.1 ≦ (pKaM - pKaY) ≦ 2.5}$ wherein pKaM and pKaY are pKa values of said magenta and yellow couplers, respectively.

5. The color photographic material of claim 1, wherein said photographic material further has a green light-sensitive layer containing a green light-sensitive silver halide emulsion and a yellow coupler.

6. The color photographic material of claim 1, wherein said silver halide grains have a chloride content of 90 mol% or more.

7. The color photographic material of claim 6, wherein said silver halide grains comprise silver chloride or silver bromochloride.

8. A method of preparing a color proof by subjecting a silver halide color photographic light-sensitive material to light-exposure based on halftone dot image information comprised of color-separated yellow, magenta and cyan image information, and black image information, wherein said silver halide color photographic light sensitive material is the color photographic material as claimed in claim 1.
